# EUROPEAN PATENT APPLICATION

(11) **EP 1 213 776 A2**
(43) Date of publication of application: **12.06.2002**
(21) Application number: 01129122.6
(22) Date of filing: 07.12.2001
(51) Int. Cl.: H01L 51/30, H01G 9/20

(54) **Metal complex dye for a dye sensitized solar cell**

(30) Priority: 08.12.2000 JP 2000375146
(71) Applicant: FUJI PHOTO FILM CO., LTD., Kanagawa-ken (JP)
(72) Inventor: Watanabe, Tetsuya, Minami-Ashigara-shi, Kanagawa-ken (JP)
(74) Representative: Patentanwälte Dr. Solf & Zapf

(57) **Abstract**

A photoelectric conversion device comprising a semiconductor fine particle sensitized by a dye having a proton dissociative imide group, and a photoelectric cell comprising the photoelectric conversion device. A metal complex dye useful for the photoelectric conversion device is also provided.

## Description

### BACKGROUND OF THE INVENTION

The present invention relates to a photoelectric conversion device comprising a semiconductor fine particle sensitized by a dye, a photoelectric cell using the photoelectric conversion device, and a metal complex dye useful therefor.

To put solar power generation into practical use, solar cells utilizing monocrystalline silicon, polycrystalline silicon, amorphous silicon, a compound such as cadmium telluride and indium copper selenide, etc. have been mainly researched and developed. However, such problems as high production cost, difficulty in security of raw materials and a long energy payback time must be overcome for a widespread use of the solar cells as a home power source, etc. Although a variety of solar cells using an organic material are also proposed with the objects of increasing surface area and reducing costs, such solar cells have disadvantages of low conversion efficiency and poor durability.

Under such circumstances, Nature, Vol. 353, Page 737 to 740 (1991), United States Patent No. 4,927,721, WO 94/04497, etc. have disclosed photoelectric conversion devices and solar cells comprising a semiconductor fine particle sensitized by a dye, and materials and production methods therefor. The solar cells are a wet-type solar cell using a titanium dioxide porous thin film spectrally sensitized by a ruthenium complex dye as a working electrode. The primary advantage for the wet-type solar cells is that they can be produced with low costs because they can use an inexpensive metal oxide semiconductor such as titanium dioxide without purification to a high purity. The secondary advantage is that the wet-type solar cells can convert light in almost entire visible wavelength region to electricity because the dye used therein has a broad absorption spectrum.

In such wet-type solar cells, open circuit voltage theoretically depends on a conduction band of the oxide semiconductor and redox level of an electrolyte. For example, theoretical open circuit voltage is approximately 1.1 V or more when titanium oxide is used as the oxide semiconductor and I⁻/I₃⁻ is used as the electrolyte. However, a solar cell exhibiting such a high open circuit voltage have not been known, and it has been hoped to improve the open circuit voltage to increase photoelectric conversion efficiency of the solar cell.

### OBJECT AND SUMMARY OF THE INVENTION

An object of the present invention is to provide a dye-sensitized photoelectric conversion device exhibiting a high open circuit voltage, a photoelectric cell using the photoelectric conversion device, and a metal complex dye useful therefor.

As a result of intense research in view of the above object, the inventor has found that a photoelectric conversion device using a dye with a particular imide group exhibits a high open circuit voltage. The present invention has been accomplished by the finding.

Thus, a photoelectric conversion device of the present invention comprises a semiconductor fine particle sensitized by a dye, wherein the dye has a proton dissociative imide group.

In the photoelectric conversion device, the proton dissociative imide group preferably has a pKa value of 14 or less. The dye preferably has a -V₁-NH-V₂- group in which V₁ and V₂ independently represent -CO-, -SO-, -SO₂- or -PO₂-. Further, the dye is preferably a metal complex dye, and particularly preferably a metal complex dye represented by the following general formula (I):

M(La)ₘ₁(Lb)ₘ₂(X)ₘ₃·Cl (I)

wherein M is a metal atom;
La is a bidentate or tridentate ligand represented by the following general formula (II): 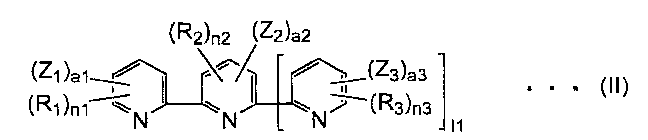 wherein Z₁, Z₂ and Z₃ independently represent a dissociative -V₁-NH-V₂-R group in which V₁ and V₂ independently represent -CO-, -SO-, -SO₂- or -PO₂-and R represents a hydrogen atom, an aliphatic hydrocarbon group, an aromatic hydrocarbon group, a heterocyclic group, an amino group or an alkoxy group, R₁, R₂ and R₃ independently represent a substituent, a1, a2 and a3 independently represent an integer of 0 to 2, the total of a1 and a2 is 1 to 4, R's may be the same or different and may bond together when the total of a1, a2 and a3 is 2 or more, n1, n2 and n3 independently represent an integer of 0 to 4, R₁'s may be the same or different substituents that may bond together when n1 is 2 or more, R₂'s may be the same or different substituents that may bond together when n2 is 2 or more, R₃'s may be the same or different substituents that may bond together when n3 is 2 or more, 11 represents an integer of 0 or 1, and Z₂ and R₂ may bond to the carbon atom adjacent to the nitrogen atom of the pyridine ring when 11 is 0;
Lb is a bidentate or tridentate ligand represented by the following general formula (III): 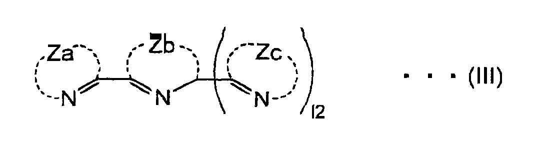 wherein Za, Zb and Zc independently represent nonmetallic atoms forming a 5-or 6-membered ring and 12 represents an integer of 0 or 1;
X is a monodentate or bidentate ligand;
m1 is an integer of 1 to 3, m2 is an integer of 0 to 2 and m3 is an integer of 0 to 4; and
CI is a counter ion optionally contained to neutralize charge of the metal complex dye.

In the metal complex dye represented by the general formula (I), it is preferred that Z₁, Z₂ and Z₃ independently represent a -CONHSO₂R group, a - CONHCOR group, a -SO₂NHSO₂R group or a -SO₂NHCOR group, and it is preferred that m1 is 2 or 3 and m2 is 0. Further, the semiconductor fine particle is particularly preferably a titanium oxide fine particle.

A photoelectric cell of the present invention comprises the above photoelectric conversion device of the present invention.

### BRIEF DESCRIPTION OF THE DRAWINGS

Fig. 1 is a partial cross sectional view showing a preferable structure of a photoelectric conversion device of the present invention;
Fig. 2 is a partial cross sectional view showing a preferable structure of a photoelectric conversion device of the present invention;
Fig. 3 is a partial cross sectional view showing a preferable structure of a photoelectric conversion device of the present invention;
Fig. 4 is a partial cross sectional view showing a preferable structure of a photoelectric conversion device of the present invention;
Fig. 5 is a partial cross sectional view showing a preferable structure of a photoelectric conversion device of the present invention;
Fig. 6 is a partial cross sectional view showing a preferable structure of a photoelectric conversion device of the present invention;
Fig. 7 is a partial cross sectional view showing a preferable structure of a photoelectric conversion device of the present invention;
Fig. 8 is a partial cross sectional view showing a preferable structure of a photoelectric conversion device of the present invention; and
Fig. 9 is a partial cross sectional view showing a preferable structure of a photoelectric conversion device of the present invention.

### DETAILED DESCRIPTION OF THE PREFERRED EMBODIMENTS

### [I] Dye

A dye used for a photoelectric conversion device of the present invention has a proton dissociative imide group. The proton dissociative imide group is such an imide group that can release a proton to be anionized. The proton dissociative imide group acts as an interlocking group to improve adsorbing properties of the dye to a semiconductor fine particle. The proton dissociative imide group preferably has a pKa value of 14 or less in water at 25 °C. The pKa value is more preferably 1 to 14, furthermore preferably 2 to 10, particularly preferably 3 to 7. The dye preferably has a -V₁-NH-V₂- group in which V₁ and V₂ independently represent -CO-, -SO-, -SO₂- or -PO₂-.

The dye used in the photoelectric conversion device of the present invention is preferably a metal complex dye, and particularly preferably a metal complex dye represented by the following general formula (I):

M(La)ₘ₁(Lb)ₘ₂(x)ₘ₃·Cl (I)

The metal complex dye represented by the general formula (I) will be described in detail below. Incidentally, if the metal complex dye has an alkyl group, an alkenyl group, an alkynyl group, an alkylene group, etc., these groups may have a straight or branched structure and may be substituted or unsubstituted. Further, when the metal complex dye has an aryl group, a heterocyclic group, a cycloalkyl group, etc., these groups may have a monocyclic structure or a polycyclic structure such as a condensed ring and a ring assemblage, and may be substituted or unsubstituted.

### (A) Metal Atom M

In the general formula (I), M is a metal atom. M is preferably such a metal atom that can form a four- or six-coordinated complex, more preferably Ru, Fe, Os, Cu, W, Cr, Mo, Ni, Pd, Pt, Co, Ir, Rh, Re, Mn or Zn, furthermore preferably Ru, Fe, Os or Cu, particularly preferably Ru.

### (B) Ligand La

In the general formula (I), La is a bidentate or tridentate ligand represented by the following general formula (II):

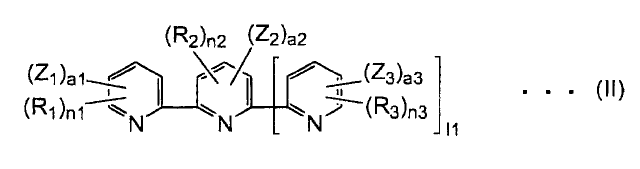

In the general formula (II), Z₁, Z₂ and Z₃ independently represent a dissociative group of -V₁-NH-V₂-R, in which V₁ and V₂ independently represent -CO-, -SO-, -SO₂- or -PO₂- and R represents a hydrogen atom, an aliphatic hydrocarbon group, an aromatic hydrocarbon group, a heterocyclic group, an amino group or an alkoxy group. R is preferably an alkyl group, an amino group or an aryl group, more preferably an alkyl group. It is preferred that Z₁, Z₂ and Z₃ independently represent a -CONHSO₂R group, a -CONHCOR group, a -SO₂NHSO₂R group or a -SO₂NHCOR group. In the case where the total number of Z₁, Z₂ and Z₃ is 2 or more, thus, where the total of a1, a2 and a3 is 2 or more, R's may be the same or different and may bond together. It is preferable that a hydrogen atom is dissociated from the imide group of Z₁, Z₂ and Z₃. Each of Z₁, Z₂ and Z₃ preferably has a pKa value of 14 or less.

In the general formula (II), R₁, R₂ and R₃ independently represent a substituent. Each of R₁, R₂ and R₃ is preferably an alkyl group, an alkenyl group, a cycloalkyl group, an aryl group, a heterocyclic group, an amino group, an alkoxy group, an acyl group, an alkoxycarbonyl group, a carboxylic acid group, a phosphonic acid group, a phosphate group, a silicic acid group, a hydroxyl group or a sulfonic acid group, more preferably an alkyl group, an amino group or an alkoxy group, particularly preferably an alkyl group.

In the general formula (II), a1, a2 and a3 independently represent an integer of 0 to 2, the total of a1 and a2 being 1 to 4. Each of a1, a2 and a3 is preferably 1 or 2, particularly preferably 1.

In the general formula (II), n1, n2 and n3 independently represent an integer of 0 to 4. R₁'s may be the same or different substituents that may bond together when n1 is 2 or more, R₂'s may be the same or different substituents that may bond together when n2 is 2 or more, and R₃'s may be the same or different substituents that may bond together when n3 is 2 or more.

In the general formula (II), 11 represents an integer of 0 or 1. When 11 is 0, Z₂ and R₂ may bond to the carbon atom adjacent to the nitrogen atom of the pyridine ring, in other words, Z₂ and R₂ may bond to the position at which the pyridine ring optionally having Z₃ and R₃ may bond.

In the general formula (I), m1 indicating the number of La is an integer of 1 to 3. When La is a bidentate ligand, m1 is preferably 2 or 3, particularly preferably 3. When La is a tridentate ligand, m1 is preferably 1 or 2, particularly preferably 2.

Specific examples of the ligand La represented by the general formula (II) will be illustrated below without intention of restricting the scope of the present invention defined by the claims attached hereto.

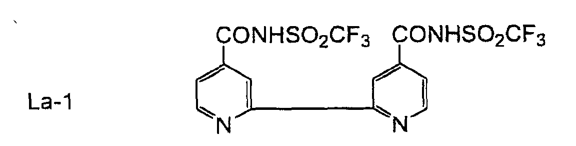

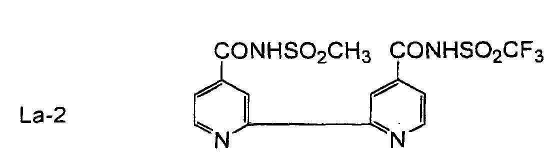

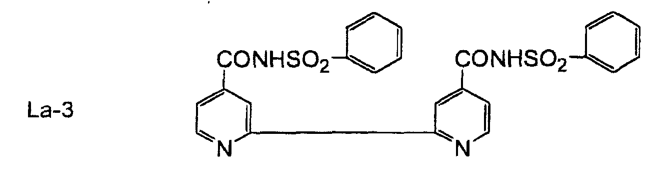

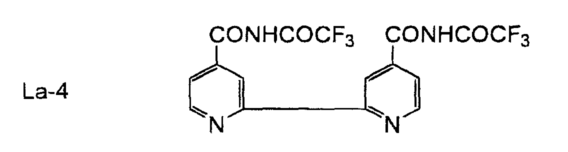

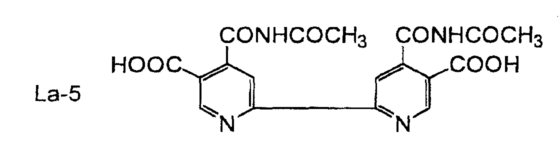

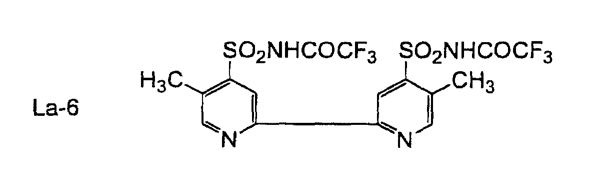

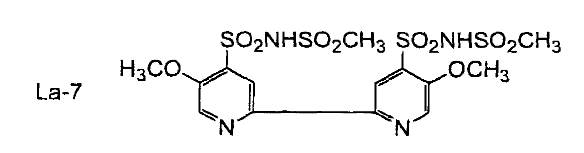

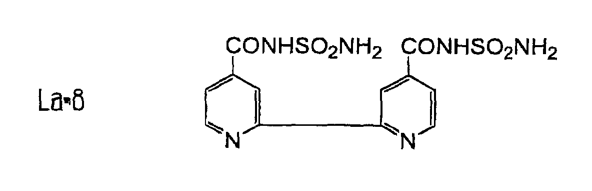

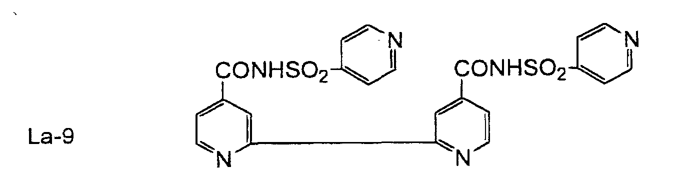

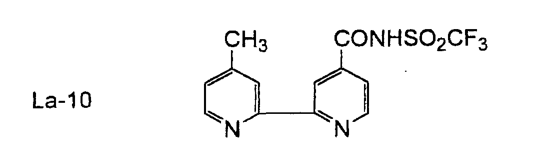

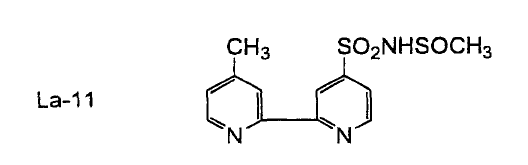

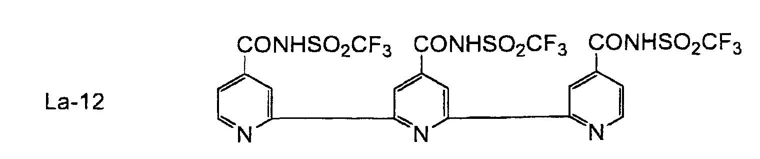

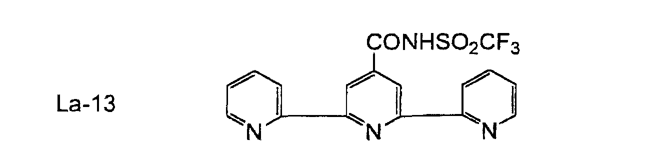

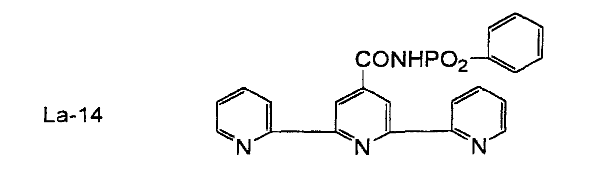

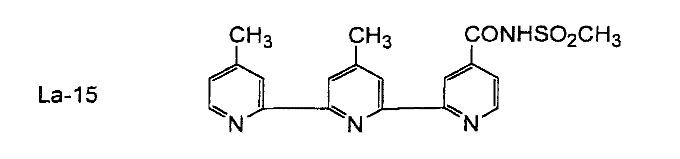

### (C) Ligand Lb

In the general formula (I), Lb is a bidentate or tridentate ligand represented by the following general formula (III). m2 indicating the number of Lb is an integer of 0 to 2, preferably 0.

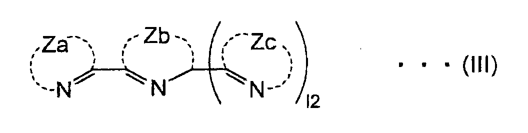

In the general formula (III), Za, Zb and Zc independently represent nonmetallic atoms forming a 5- or 6-membered ring. Za, Zb and Zc are preferably composed of atoms selected from the group consisting of carbon, hydrogen, nitrogen, oxygen, sulfur, phosphorus and halogen atoms, and preferably from an aromatic ring. The 5-membered ring is preferably an imidazole ring, an oxazole ring, a thiazole ring or a triazole ring. The 6-membered ring is preferably a pyridine ring, a pyrimidine ring, a pyridazine ring or a pyrazine ring. The 5- or 6-membered ring is more preferably a pyridine ring or an imidazole ring, particularly preferably a pyridine ring.

In the general formula (III), 12 represents an integer of 0 or 1.

Specific examples of the ligand Lb represented by the general formula (III) will be illustrated below without intention of restricting the scope of the present invention defined by the claims attached hereto.

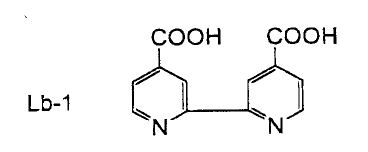

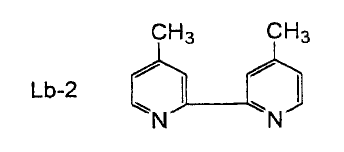

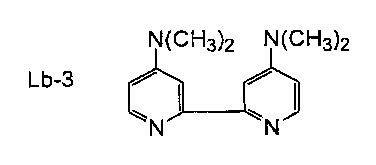

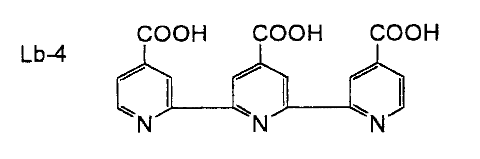

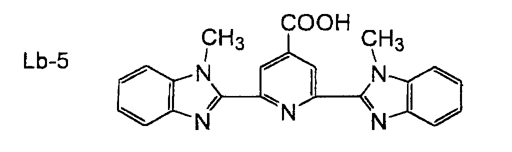

### (D) Ligand X

In the general formula (I), X is a monodentate or bidentate ligand. m3 indicating the number of X is an integer of 0 to 4, preferably 1 or 2. X's may be the same or different ligands that may bond together when m3 is 2 or more.

Examples of X include monodentate or bidentate ligands that coordinate to the metal atom via one or two group selected from the group consisting of: acyloxy groups preferably having 1 to 20 carbon atom such as an acetyloxy group, a benzoyloxy group, a salicyloyloxy group, a glycyloxy group, an *N,N*-dimethylglycyloxy group and an oxalylene group (-OC(O)C(O)O-); acylthio groups preferably having 1 to 20 carbon atom such as an acetylthio group and a benzoylthio group; thioacyloxy groups preferably having 1 to 20 carbon atom such as a thioacetyloxy group (CH₃C(S)O-); thioacylthio groups preferably having 1 to 20 carbon atom such as a thioacetylthio group (CH₃C(S)S-) and a thiobezoylthio group (PhC(S)S-); acylaminoxy groups preferably having 1 to 20 carbon atom such as an *N*-methylbenzoylaminoxy group (PhC(O)N(CH₃)O-) and an acetylaminoxy group (CH₃C(O)NHO-); thiocarbamate groups preferably having 1 to 20 carbon atom such as an *N,N*-diethylthiocarbamate group; dithiocarbamate groups preferably having 1 to 20 carbon atom such as an *N*-phenyldithiocarbamate group, an *N,N*-dimethyldithiocarbamate group, an *N,N*-diethyldithiocarbamate group and an *N,N*-dibenzyldithiocarbamate group; thiocarbonate groups preferably having 1 to 20 carbon atom such as an ethylthiocarbonate group; dithiocarbonate groups preferably having 1 to 20 carbon atom such as an ethyldithiocarbonate group (C₂H₅OC(S)S-); trithiocarbonate groups preferably having 1 to 20 carbon atom such as an ethyltrithiocarbonate group (C₂H₅SC(S)S-); acyl groups preferably having 1 to 20 carbon atom such as an acetyl group and a benzoyl group; a thiocyanate group; an isothiocyanate group; a cyanate group; an isocyanate group; a cyano group; alkylthio groups preferably having 1 to 20 carbon atom such as a methylthio group and an ethylenedithio group; arylthio groups preferably having 6 to 20 carbon atoms such as a benzenethio group and a 1,2-phenylenedithio group; alkoxy groups preferably having 1 to 20 carbon atom such as a methoxy group; and aryloxy groups preferably having 6 to 20 carbon atoms such as a phenoxy group and an 8-hydroxyquinolyl group.

Examples of X further include: halogen atoms such as a chlorine atom, a bromine atom and an iodine atom; carbonyl (···CO); dialkylketones preferably having 3 to 20 carbon atoms such as acetone ((CH₃)₂CO···); 1,3-diketones preferably having 3 to 20 carbon atoms such as acetylacetone (CH₃C(O ···)CH=C(O-)CH₃), trifluoroacetylacetone (CH₃C(O···)CH=C(O-)CF₃), dipivaloylmethane (*t*-C₄H₉C(O···)CH=C(O-)-*t*-C₄H₉), dibenzoylmethane (PhC(O···)CH=C(O-)Ph) and 3-chloroacetylacetone (CH₃C(O···)CCl=C(O-)CH₃); carbonamides preferably having 1 to 20 carbon atom such as CH₃N=C(CH₃)O- and -OC(=NH)-C(=NH)O-; thiocarbonamides preferably having 1 to 20 carbon atom such as CH₃N=C(CH₃)S-; and thioureas preferably having 1 to 20 carbon atom such as ···NH=C(NH₂)S-, ···N(CH₃)=C(NHCH₃)S-and (CH₃)₂N-C(S···)N(CH₃)₂. Incidentally, "···" represents a coordinate bond.

### (E) Counter Ion CI

In the general formula (I), CI is a counter ion optionally contained in the metal complex dye to neutralize charge of the dye. Whether the metal complex dye is cationic or anionic without the counter ion and whether the metal complex dye has an ionic charge or not without the counter ion depend on the metal atom, the ligand(s) and the substituent(s) thereof. When the metal complex dye comprises a dissociative group, it may be dissociated so that the metal complex dye has a charge. In such a case, the charge may be neutralized by CI.

Typical examples of a positive counter ion represented by CI include: inorganic and organic ammonium ions such as tetralkyl ammonium ions and a pyridinium ion; alkali metal ions; and proton. A negative counter ion represented by CI may be inorganic or organic, and examples thereof include: halide ions such as a fluoride ion, a chloride ion, a bromide ion and an iodide ion; substituted aryl sulfonate ions such as a *p*-toluene sulfonate ion and a *p*-chlorobenzene sulfonate ion; aryl disulfonate ions such as a 1,3-benzene disulfonate ion, a 1,5-naphthalene disulfonate ion and a 2,6-naphthalene disulfonate ion; alkyl sulfate ions such as a methyl sulfate ion; a sulfate ion; an nitrate ion; a thiocyanate ion; a perchlorate ion; a tetrafluoroborate ion; a hexafluorophosphate ion; a picrate ion; an acetate ion; a trifluoromethane sulfonate ion; etc. Further, the counter ion may be a charge-balancing counter ion such as an ionic polymer and another dye having a charge opposite to that of the metal complex dye of the general formula (I). Metal complex ion such as bisbenzene-1,2-dithiolato nickel (III) may be used as the counter ion.

### (F) Interlocking Group

The metal complex dye represented by the general formula (I) preferably has an interlocking group, which can interact or adsorb to the semiconductor fine particles, other than the proton dissociative imide group of -V₁-NH-V₂-R contained in the ligand La. The number of the interlocking group is preferably 1 to 6, more preferably 1 to 4. Preferred interlocking groups other than the imide group include acidic groups having a dissociative hydrogen atom, for example, a carboxyl group, a sulfonic acid group, a hydroxyl group, hydroxamic acid groups such as -CONHOH, phosphoryl groups such as -OP(O)(OH)₂, phosphonyl groups such as -P(O)(OH)₂, etc. The interlocking group is preferably disposed on La or Lb in the general formula (I).

### (G) Specific Examples of Dye

Specific examples of the dye used in the present invention will be illustrated below without intention of restricting the scope of the present invention defined by the claims attached hereto. Incidentally, a dissociative atom or group contained in the specific examples is optionally dissociated.

Ru(La)ₘ₁(Lb)ₘ₂(X)ₘ₃

| | La | m1 | Lb | m2 | X | m₃ |
|---|---|---|---|---|---|---|
| S-1 | La-1 | 2 | - | 0 | NCS | 2 |
| S-2 | La-1 | 1 | Lb-1 | 1 | NCS | 2 |
| S-3 | La-2 | 2 | - | 0 | NCS | 2 |
| S-4 | La-3 | 2 | - | 0 | NCS | 2 |
| S-5 | La-4 | 2 | - | 0 | NCS | 2 |
| S-6 | La-5 | 3 | - | 0 | - | 0 |
| S-7 | La-12 | 1 | - | 0 | NCS | 3 |
| S-8 | La-13 | 1 | Lb-3 | 1 | Cl | 1 |
| S-9 | La-13 | 2 | - | 0 | - | 0 |

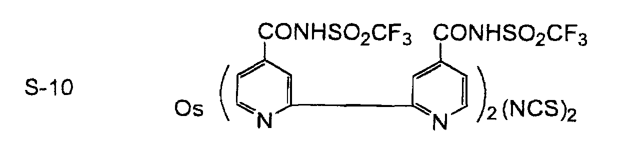

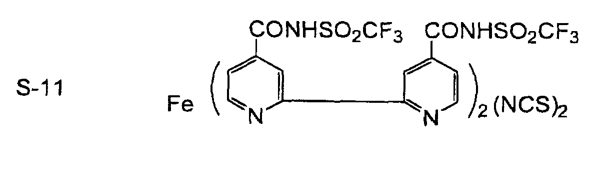

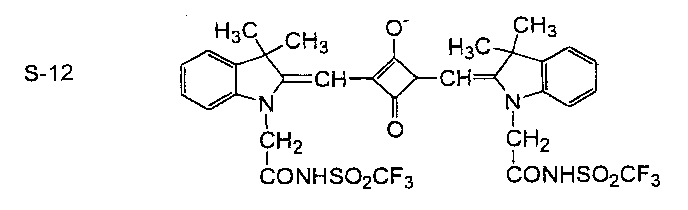

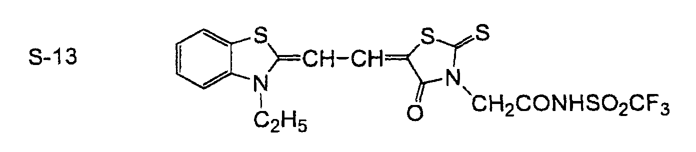

In the present invention, the dye having the proton dissociative imide group may be used for the photoelectric conversion device in combination with a known dye such as a ruthenium complex dye, an organic dye, etc.

### [2] Photoelectric Conversion Device

A photoelectric conversion device of the present invention comprises a semiconductor fine particle sensitized by the above-mentioned dye having the proton dissociative imide group.

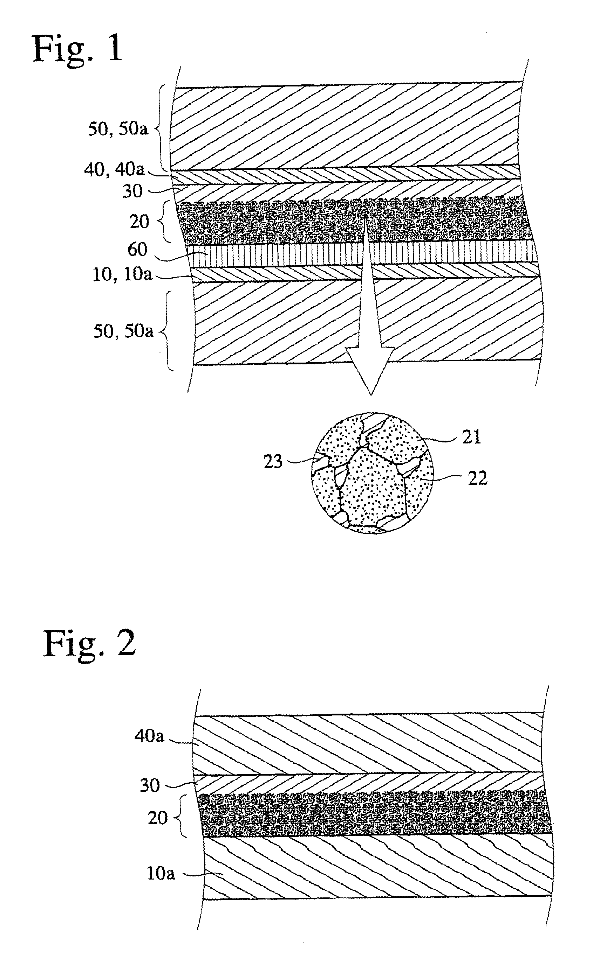

As shown in Fig. 1, the photoelectric conversion device of the present invention preferably comprises: an electrically conductive layer 10; a photosensitive layer 20 containing semiconductor fine particles 21 sensitized by the dyes 22 and an charge-transporting material 23 penetrated into voids among the particles; a charge transfer layer 30; and a counter electrically conductive layer 40 laminated in this order. An undercoating layer 60 may be disposed between the electrically conductive layer 10 and the photosensitive layer 20. The charge-transporting material 23 is generally the same as the material used for the charge transfer layer 30. On the electrically conductive layer 10 and/or the counter electrically conductive layer 40 may be disposed a substrate 50 to improve the strength of the photoelectric conversion device. In the present invention, a layer composed of the electrically conductive layer 10 and the substrate 50 disposed thereon if necessary is referred to as "conductive support", and a layer composed of the counter electrically conductive layer 40 and the substrate 50 disposed thereon if necessary is referred to as "counter electrode". Incidentally, the electrically conductive layer 10, the counter electrically conductive layer 40 and the substrate 50 shown in Fig. 1 may be a transparent electrically conductive layer 10a, a transparent counter electrically conductive layer 40a and a transparent substrate 50a, respectively.

A photoelectric cell is constituted by connecting the photoelectric conversion device to an external circuit to electrically work or generate electricity in the external circuit. A photosensor is such a photoelectric conversion device as sensing optical information. Such a photoelectric cell that has the charge transfer layer composed of an ion conductive material is referred to as a photo-electrochemical cell. A photoelectric cell intended for power generation using solar light is referred to as a solar cell.

In the photoelectric conversion device shown in Fig. 1, in the case of using *n*-type semiconductor fine particles, a light injected to the photosensitive layer 20 excites the dyes 22, etc., excited high energy electrons therein are transported to a conduction band of the semiconductor fine particles 21, and they are diffused to reach to the electrically conductive layer 10. At this time, the dyes 22 are in oxidized form. In a photoelectric cell composed of the photoelectric conversion device, electrons in the electrically conductive layer 10 are returned to the oxidized dyes through the counter electrically conductive layer 40 and the charge transfer layer 30 while working in the external circuit, so that the dyes 22 are regenerated. The photosensitive layer 20 generally acts as a negative electrode (or a photoanode), and the counter electrically conductive layer 40 generally acts as a positive electrode. In a boundary of each layer such as a boundary between the electrically conductive layer 10 and the photosensitive layer 20, a boundary between the photosensitive layer 20 and the charge transfer layer 30, a boundary between the charge transfer layer 30 and the counter electrically conductive layer 40, etc., contents of each layer may be diffused and mixed.

Each layer comprised in the photoelectric conversion device of the present invention will be explained in detail below.

### (A) Conductive Support

The conductive support is composed of (1) a single layer of the electrically conductive layer, or (2) two layers of the electrically conductive layer and the substrate. In the case of (1), the electrically conductive layer is preferably made of a material having a sufficient strength that can sufficiently seal the photoelectric conversion device, for example, a metal such as platinum, gold, silver, copper, zinc, titanium, aluminum and an alloy composed thereof. In the case of (2), the substrate on which the electrically conductive layer containing an electrically conductive material is disposed at the photosensitive layer side may be used as the conductive support. Preferable examples of the electrically conductive material include: metals such as platinum, gold, silver, copper, zinc, titanium, aluminum, indium and alloys composed thereof; carbon; electrically conductive metal oxides such as indium-tin composite oxides and tin oxides doped with fluorine or antimony; etc. The electrically conductive layer preferably has a thickness of 0.02 to 10 µm.

The surface resistance of the conductive support is desirable as low as possible. The surface resistance is preferably 50 Ω/square or less, more preferably 20 Ω/square or less.

When light is irradiated from the conductive support side, it is preferred that the conductive support is substantially transparent. Herein, the term "being substantially transparent" means that the light transmittance is 10 % or more to a light in visible region to near infrared region (400 to 1200 nm). The light transmittance is preferably 50 % or more, more preferably 80 % or more. The conductive support particularly preferably has high light transmittance to a light that the photosensitive layer has sensitivity to.

The transparent conductive support is preferably constituted by disposing the transparent electrically conductive layer of an electrically conductive metal oxide on the transparent substrate of such material as a glass and a plastic by means of coating or vapor deposition. The transparent electrically conductive layer is preferably made of tin dioxide doped with fluorine or antimony, or indium-tin oxide (ITO). The transparent substrate may be made of a glass such as a low-cost soda glass excellent in strength and a non-alkali glass that occurs no alkaline elution. Additionally, a transparent polymer film is preferably used as the transparent substrate. Used as the materials for the transparent polymer film may be tetracetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyimide (PI), polyetherimide (PEI), cyclic polyolefin, brominated phenoxy resin, etc. To secure a sufficient transparency, the coating amount of the electrically conductive metal oxide is preferably 0.01 to 100 g per 1 m² of the glass or plastic substrate.

It is preferable that a metal lead is used to reduce the resistance of the transparent conductive support. The metal lead is preferably made of a metal such as platinum, gold, nickel, titanium, aluminum, copper, silver, etc. It is preferable that the metal lead is provided on the transparent substrate by a vapor deposition method, a sputtering method, etc., the transparent electrically conductive layer of conductive tin oxide or ITO being disposed thereon. The reduction in incident light quantity owing to the metal lead is suppressed to preferably 10 % or less, more preferably 1 to 5 %.

### (B) Photosensitive Layer

The photosensitive layer comprises the semiconductor fine particle sensitized by the dye having the proton dissociative imide group. In the photosensitive layer, the semiconductor fine particle acts as a photosensitive substance to absorb a light and conduct charge separation, thereby generating electrons and positive holes. In the dye-sensitized semiconductor fine particle, the light absorption and the generation of the electrons and the positive holes are primarily caused in the dye, and the semiconductor fine particle receives and conveys the electrons or the positive holes.

### (1) Semiconductor

Used as the semiconductor may be: an elementary substance semiconductor such as silicon and germanium; a III-V series compound semiconductor; a metal chalcogenide such as a metal oxide, a metal sulfide, a metal selenide and a composite thereof; a compound having a perovskite structure such as strontium titanate, calcium titanate, sodium titanate, barium titanate and potassium niobate; etc. An *n*-type semiconductor is preferably used in the present invention, in which conductor electrons act as a carrier under photo-excitation condition to provide anode current.

Preferable examples of the metal chalcogenide include: oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; cadmium telluride; etc. Additionally, compound semiconductors such as phosphides of zinc, gallium, indium or cadmium, selenides of gallium-arsenic or copper-indium, copper-indium sulfide, etc. may be used in this invention. Further, composite semiconductors such as MₓO_{y}S_{z} and M₁ₓM_{2y}O_{z} are also preferably used in the present invention, in which M, M₁ and M₂ independently represent a metal atom, O represents an oxygen atom, S represents a sulfur atom, and x, y and z represent numbers combined with each other to form a neutral molecule.

Preferable specific examples of the semiconductor include Si, TiO₂, SnO₂, Fe₂O₃, WO₃, ZnO, Nb₂O₅, CdS, ZnS, PbS, Bi₂S₃, CdSe, CdTe, SrTiO₃, GaP, InP, GaAs, CuInS₂ and CuInSe₂. Of these semiconductors, more preferred are TiO₂, SnO₂, Fe₂O₃, WO₃, ZnO, Nb₂O₅, CdS, PbS, CdSe, SrTiO₃, InP, GaAs, CuInS₂ and CuInSe₂, furthermore preferred are TiO₂ and Nb₂O₅, and particularly preferred is TiO₂. TiO₂ contains anatase-type crystal structure of preferably 70 volume % or more, particularly preferably 100 volume %. It is preferable that the semiconductor is doped with a metal to increase electron conductivity thereof. This metal is preferably divalent or trivalent. Further, the semiconductor is preferably doped with a monovalent metal to prevent a reverse current from the semiconductor to the charge transfer layer.

The semiconductor may have a single crystal or poly crystal structure. The poly crystal semiconductor is preferred from the viewpoints of the production costs, security of the raw materials, the energy-payback time, etc. The photosensitive layer is particularly preferably a porous semiconductor fine particle layer. The photosensitive layer may partly contain an amorphous semiconductor.

The particle size of the semiconductor fine particle is generally in the nm to µm level. The average size of primary semiconductor particles, which is obtained from a diameter of a circle equivalent to a projected area thereof, is preferably 5 to 200 nm, more preferably 8 to 100 nm. Further, the average size of secondary semiconductor particles in dispersion is preferably 0.01 to 30 µm.

Two or more of the semiconductor fine particles having a different particle size distribution may be mixed to use for the photosensitive layer. In this case, the average particle size of the smaller particles is preferably 25 nm or less, more preferably 10 nm or less. To improve a light-capturing rate of the photoelectric conversion device by scattering ray of incident light, the semiconductor fine particles having a large particle size, e.g. approximately 100 to 300 nm in diameter, may be used for the photosensitive layer.

Two or more kinds of the semiconductor fine particles may be mixed and used for the photosensitive layer. In this case, it is preferable that one is TiO₂, ZnO, Nb₂O₅ or SrTiO₃ and the other is SnO₂, Fe₂O₃ or WO₃. More preferred combination is ZnO and SnO₂, ZnO and WO₃, ZnO, SnO₂ and WO₃, etc. Each of the semiconductor fine particles may have a different diameter. Particularly preferred is a combination of TiO₂, ZnO, Nb₂O₅ or SrTiO₃ having a larger diameter and SnO₂, Fe₂O₃ or WO₃ having a smaller diameter, the larger diameter being preferably 100 nm or more, and the smaller diameter being preferably 15 nm or less.

Preferred as a method for producing the semiconductor fine particle are: sol-gel methods described in Sumio Sakka, "Zoru-Geru-Ho No Kagaku (Science of Sol-Gel Method)", Agune Shofusha (1998), Technical Information Association, "Zoru-Geru-Ho Niyoru Hakumaku Coating Gijutu (Thin Film-Coating Technology by Sol-Gel Method)" (1995), etc.; and gel-sol methods described in Tadao Sugimoto, "Shin-Goseiho Geru-Zoru-Ho Niyoru Tanbunsanryusi No Gosei To Saizu-Keitaiseigyo (Synthesis of Mono-Dispersion Particles and Control of Their Size and Form by Novel Gel-Sol Method)", and MATERIA, Vol. 35, No. 9, Page 1012 to 1018 (1996). The method developed by Degussa Company, which comprises preparing oxides by subjecting chlorides to a high temperature hydrolysis in an oxyhydrogen salt, is also preferred.

In the case of using the semiconductor fine particle of titanium oxide, any of the above-described sol-gel methods, gel-sol methods and high temperature hydrolysis method are preferably used, further, a sulfuric acid method and a chlorine method described in Manabu Seino, "Sanka-Chitan Bussei To Ouyougijutu (Titanium oxide - Properties and Applied Technique)", Gihodo Shuppan, (1997) may be used. Of the sol-gel methods, also preferred are such that described in Christophe J. Barb'e, et al, Journal of American Ceramic Society, Vol. 80, No. 12, Page 3157 to 3171 (1997) and Burnside, et al, Chemistry of Materials, Vol. 10, No. 9, Page 2419 to 2425.

### (2) Semiconductor Fine Particle Layer

The semiconductor fine particles may be applied onto the conductive support by: a method where the conductive support is coated with a dispersion or a colloidal solution containing the particles; the above-mentioned sol-gel method; etc. A wet type film production method is relatively advantageous for the mass production of the photoelectric conversion device, improvement of properties of the semiconductor fine particle solution, improvement of the adaptability of the conductive support, etc. As such a wet type film production method, coating methods, printing methods, electrolytic deposition methods and electrodeposition techniques are typical examples. Further, the semiconductor fine particle layer may be disposed by: oxidizing a metal; an LPD method where a metal solution is subjected to ligand exchange, etc.; a sputtering method; a vapor deposition method; a CVD method; or an SPD method where a thermal decomposition-type metal oxide precursor is sprayed on a heated substrate to generate a metal oxide.

The dispersion containing the semiconductor fine particles may be prepared by: the sol-gel methods mentioned above; crushing the semiconductor in a mortar; dispersing the semiconductor while grinding it in a mill; synthesizing and precipitating the semiconductor fine particles in a reaction solvent; etc.

As a dispersion solvent, water or organic solvents such as methanol, ethanol, isopropyl alcohol, citronellol, terpineol, dichloromethane, acetone, acetonitrile, ethyl acetate, etc. may be used. A polymer such as polyethylene glycol, hydroxyethylcellulose and carboxymethylcellulose, a surfactant, an acid, a chelating agent, etc. may be used as a dispersing agent, if necessary. In particular, it is preferable that polyethylene glycol is added to the dispersion because the viscosity of the dispersion and the porosity of the semiconductor fine particle layer can be controlled by changing the molecular weight of the polyethylene glycol and the semiconductor fine particle layer containing polyethylene glycol is hardly peeled off.

Preferred coating methods include: a roller method and a dip method as an application series; an air-knife method and a blade method as a metering series; etc. Further, preferable as a method where an application and metering can be carried out at the same time are a wire-bar method disclosed in JP-B-58-4589, a slide-hopper method described in United States Patent Nos. 2,681,294, 2,761,419, 2,761,791, etc., an extrusion method, a curtain method, etc. Furthermore, as for a wide use, a spin method and a spray method are preferred. As a wet type printing method, three major printing methods of a relief printing, an offset printing and a gravure printing, an intaglio printing, a gum printing, a screen printing, etc. are preferred. A preferable film production method may be selected from these methods in accordance with the viscosity of the dispersion and the desired wet thickness.

The semiconductor fine particle layer is not limited to a single layer. The dispersions each comprising the semiconductor fine particles having a different particle size may be subjected to a multi-layer coating. Further, the dispersions each containing different kinds of semiconductor fine particles, binders or additives may be subjected to a multi-layer coating. The multi-layer coating is also effectively used when the thickness of the layer is insufficient by coating of once.

Generally, when the thickness of the semiconductor fine particle layer, equal to the thickness of the photosensitive layer, becomes thicker, the amount of the dye incorporated therein per unit projected area increases to make the light-capturing rate higher. However, because diffusion distances of the generated electrons are increased in this case, loss owing to recombination of the electric charges is also increased. Consequently, the preferable thickness of the semiconductor fine particle layer is 0.1 to 100 µm. In the photoelectric cell, the thickness of the semiconductor fine particle layer is preferably 1 to 30 µm, more preferably 2 to 25 µm. An applying amount of the semiconductor fine particles per 1 m² of the substrate is preferably 0.5 to 100 g, more preferably 3 to 50 g.

After applying the semiconductor fine particles onto the conductive support, the particles are preferably subjected to a heat treatment, to electronically contact them with each other and to increase the coating strength and the adherence thereof with the support. The heating temperature is preferably 40 to 700 °C, more preferably 100 to 600 °C. The heating time is preferably 10 minutes to 10 hours. It is not preferred that the substrate having low melting point or softening point such as a polymer film substrate is subjected to a high temperature treatment because such a substrate tends to be deteriorated thereby. The heat treatment is preferably carried out at a temperature as low as possible, for example, 50 to 350 °C, also from the viewpoint of cost. The semiconductor fine particle layer containing the smaller semiconductor fine particles having a size of 5 nm or less, a mineral acid, a metal oxide precursor, etc. can be heat-treated at such a low temperature. Further, the heat treatment may be carried out while applying ultraviolet ray, infrared ray, microwave, electric field, ultrasonic wave, etc. to the semiconductor fine particles, to reduce the heating temperature. To remove unnecessary organic compounds, etc., the heat treatment is preferably carried out in combination with evacuation, oxygen plasma treatment, washing by pure water, a solvent or a gas, etc.

After the heat treatment, the semiconductor fine particle layer may be subjected to a chemical metal-plating using an titanium tetrachloride aqueous solution, etc. or an electrochemical metal-plating using an titanium trichloride aqueous solution, etc., to increase the surface area of the semiconductor fine particles, or to enhance a purity of the particles, thereby improving the electron-injecting efficiency into the particles from the dye. Further, to prevent a reverse current from the semiconductor fine particles to the charge transfer layer, on the semiconductor fine particles is preferably adsorbed an organic compound having low electron conductivity other than the dye. The organic compound preferably has a hydrophobic group.

It is preferable that the semiconductor fine particle layer has a large surface area to adsorb lots of dyes. The surface area of the semiconductor fine particle layer is preferably 10 times or more, more preferably 100 times or more of its projected area. The highest limit, even though it is not limited in particular, is generally a level of 1000 times.

### (3) Adsorption of Dye to Semiconductor Fine Particle

The dye may be adsorbed to the semiconductor fine particles by soaking the conductive support having the well-dried semiconductor fine particle layer in a dye adsorption solution, or by applying the dye adsorption solution to the semiconductor fine particle layer. In the former case, a soaking method, a dipping method, a roller method, an air-knife method, etc. may be used. In the soaking method, the dye may be adsorbed at a room temperature, or under reflux while heating as described in Japanese Patent Laid-Open No. 7-249790. As an applying method of the latter case, a wire-bar method, a slide-hopper method, an extrusion method, a curtain method, a spin method, a spray method, etc. may be used. Further, the dye may be applied to the semiconductor fine particle layer by an ink-jet method into an image, thereby providing a photoelectric conversion surface having a shape of the image.

Preferred examples of a solvent for the dye adsorption solution include: alcohols such as methanol, ethanol, *t*-butanol and benzyl alcohol; nitrile compounds such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N*-dimethylformamide and *N,N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof.

The total amount of the dye is preferably 0.01 to 100 mmol per the unit surface area (1 m²) of the conductive support. The amount of the dye adsorbed on the semiconductor fine particles is preferably 0.01 to 1 mmol per 1 g of the semiconductor fine particles. Such an adsorption amount of the dye effects a sufficient sensitization to the semiconductors. Too small amount of the dye results in insufficient sensitization effect. On the other hand, if the amount of the dye is excessive, the dye unadsorbed on the semiconductor fine particles floats to reduce the sensitization effect. To increase the adsorption amount of the dye, it is preferable that the semiconductor fine particle layer is subjected to a heat treatment before the dye is adsorbed thereon. After the heat treatment, it is preferable that the dye is quickly adsorbed on the semiconductor fine particle layer having a temperature of 60 to 150 °C before the layer is cooled to the room temperature, to prevent water from adsorbing onto the semiconductor fine particle layer.

To weaken an interaction between the dyes such as association, a colorless compound may be co-adsorbed onto the semiconductor fine particles together with the dye. The colorless compound preferably has surface activity, and examples thereof include steroid compounds having a carboxyl group such as chenodeoxycholic acid, and sulfonates shown below.

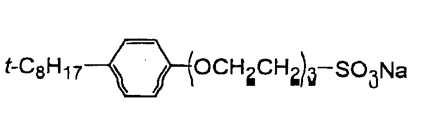

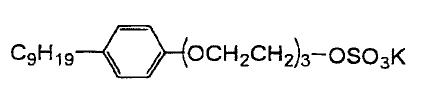

The dye unadsorbed on the semiconductor fine particle layer is preferably removed by washing immediately after the dye adsorption process. The washing is preferably carried out by a wet-type washing bath with a polar solvent such as acetonitrile or an organic solvent such as an alcohol solvent. The surface of the semiconductor fine particles may be treated with an amine compound or a quaternary salt after the dye adsorption process. The amine compound is preferably pyridine, 4-*t*-butylpyridine, polyvinylpyridine, etc., and the quaternary salt is preferably tetrabutylammonium iodide, tetrahexylammonium iodide, etc. The amine compound or the quaternary salt may be used singly if it is liquid, and may be used in a fashion of a solution in an organic solvent.

### (C) Charge Transfer Layer

The charge transfer layer replenishes electrons to the oxidized dye. The charge transfer layer may be composed of (i) an ion conductive electrolyte composition or (ii) a carrier-mediated, charge-transporting material utilizing charge transport mediated by a carrier in solid. Examples of (i) the ion conductive electrolyte composition include: molten salt electrolyte compositions containing a redox couple; electrolysis solutions where a redox couple is dissolved in a solvent; so-called gel electrolyte compositions where a solution including a redox couple is penetrated into a polymer matrix; solid electrolyte compositions; etc. Examples of (ii) the carrier-mediated, charge-transporting material include electron-transporting materials and hole-transporting materials. These materials may be used in combination with each other.

### (1) Molten Salt Electrolyte Composition

The molten salt electrolyte compositions are particularly preferably used for the charge transfer layer from the viewpoint of improving the durability and the photoelectric conversion efficiency of the photoelectric conversion device. The molten salt electrolyte composition comprises a molten salt electrolyte having a low melting point. In the present invention, pyridinium salts, imidazolium salts, triazolium salts, etc. disclosed in WO 95/18456, Japanese Patent Laid-Open No. 8-259543, "Denki Kagaku (Electrochemistry)", 65, 11, 923 (1997), etc. may be used as the molten salt electrolyte. The molten salt electrolyte preferably has the melting point of 100 °C or less, and it is particularly preferably in a liquid state at the room temperature.

The molten salt electrolytes represented by any of the following general formulae (Y-a), (Y-b) and (Y-c) are preferably used in the present invention.

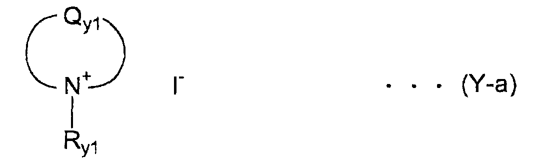

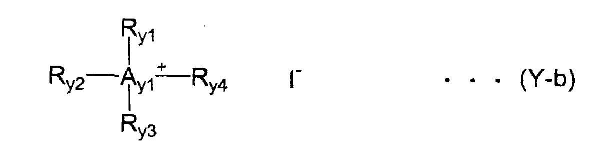

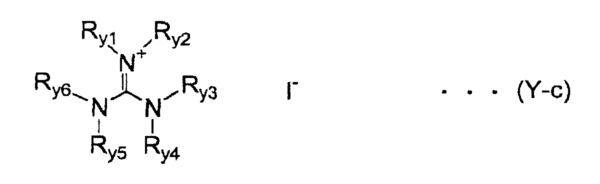

In the general formula (Y-a), Q_{y1} represents an atomic group forming an aromatic cation having a 5- or 6-membered ring structure with the nitrogen atom. Q_{y1} is preferably composed of atoms selected from the group consisting of carbon, hydrogen, nitrogen, oxygen and sulfur atoms. The 5-membered ring formed by Q_{y1} is preferably an oxazole ring, a thiazole ring, an imidazole ring, a pyrazole ring, an *iso*-oxazole ring, a thiadiazole ring, an oxadiazole ring, a triazole ring, an indole ring or a pyrrole ring, more preferably an oxazole ring, a thiazole ring or an imidazole ring, particularly preferably an oxazole ring or an imidazole ring. The 6-membered ring formed by Q_{y1} is preferably a pyridine ring, a pyrimidine ring, a pyridazine ring, a pyrazine ring or a triazine ring, more preferably a pyridine ring.

In the general formula (Y-b), A_{y1} represents a nitrogen atom or a phosphorus atom.

R_{y1} to R_{y6} in the general formulae (Y-a), (Y-b) and (Y-c) independently represent: a substituted or unsubstituted alkyl group preferably having 1 to 24 carbon atom, which may be straight, branched or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or a substituted or unsubstituted alkenyl group preferably having 2 to 24 carbon atoms, which may be straight or branched, such as a vinyl group, an allyl group, etc. R_{y1} to R_{y6} is more preferably an alkyl group having 2 to 18 carbon atoms or an alkenyl group having 2 to 18 carbon atoms, particularly preferably an alkyl group having 2 to 6 carbon atoms, respectively.

Two or more of R_{y1} to R_{y4} in the general formula (Y-b) may be bonded together to form a non-aromatic ring containing A_{y1}. Two or more of R_{y1} to R_{y6} in the general formula (Y-c) may be bonded together to form a ring.

Q_{y1} and R_{y1} to R_{y6} in the general formulae (Y-a), (Y-b) and (Y-c) may have a substituent, respectively. Preferable examples of the substituent include: halogen atoms such as F, Cl, Br and I; cyano group; alkoxy groups such as a methoxy group, an ethoxy group, a methoxyethoxy group and a methoxyethoxyethoxy group; aryloxy groups such as a phenoxy group; alkylthio groups such as a methylthio group and an ethylthio group; alkoxycarbonyl groups such as an ethoxycarbonyl group; carbonate groups such as an ethoxycarbonyloxy group; acyl groups such as an acetyl group, a propionyl group and a benzoyl group; sulfonyl groups such as a methanesulfonyl group and a benzenesulfonyl group; acyloxy groups such as an acetoxy group and a benzoyloxy group; sulfonyloxy groups such as a methanesulfonyloxy group and a toluenesulfonyloxy group; phosphonyl groups such as a diethylphosphonyl group; amido groups such as an acetylamino group and a benzoylamino group; carbamoyl groups such as an *N,N*-dimethylcarbamoyl group; alkyl groups such as a methyl group, an ethyl group, a propyl group, an isopropyl group, a cyclopropyl group, a butyl group, a 2-carboxyethyl group and a benzyl group; aryl groups such as a phenyl group and a toluyl group; heterocyclic groups such as a pyridyl group, an imidazolyl group and a furanyl group; alkenyl groups such as a vinyl group and a 1-propenyl group; silyl groups; silyloxy groups; etc.

The molten salt electrolytes represented by the general formula (Y-a), (Y-b) or (Y-c) may form an oligomer or a polymer through any one of Q_{y1} and R_{y1} to R_{y6}.

The molten salt electrolytes may be used singly or in combination with each other. Further, I⁻ of the molten salt electrolytes represented by the general formula (Y-a), (Y-b) or (Y-c) may be replaced into the other anion. The other anion is preferably a halide ion such as Cl⁻ and Br⁻, SCN⁻, BF₄⁻, PF₆⁻, ClO₄⁻, N⁻ (SO₂CF₃)₂, N⁻(SO₂CF₂CF₃)₂, CH₃SO₃⁻, CF₃SO₃⁻, CF₃COO⁻, BPh₄⁻, C⁻(SO₂CF₃)₃, etc., more preferably SCN⁻, BF₄⁻, N⁻(SO₂CF₃)₂, CF₃SO₃⁻ or CF₃COO⁻. Also, the molten salt electrolyte represented by the general formula (Y-a), (Y-b) or (Y-c) may be used in combination with another iodine salt such as LiI or an alkali metal salt such as CF₃COOLi, CF₃COONa, LiSCN and NaSCN. Weight ratio of the alkali metal salt is preferably 0.02 to 2 weight %, more preferably 0.1 to 1 weight %, to 100 weight % of the molten salt electrolyte composition.

The molten salt electrolytes preferably used in the present invention will be illustrated below without intention of restricting the scope of the present invention defined by the claims attached hereto.

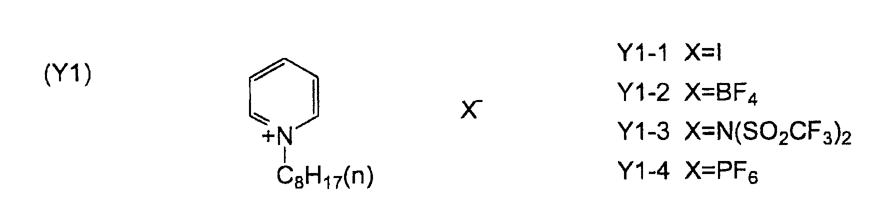

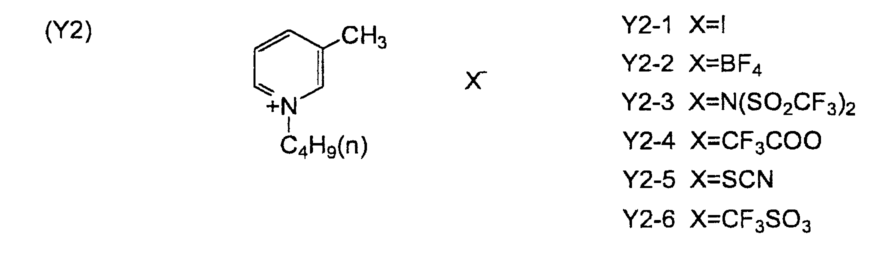

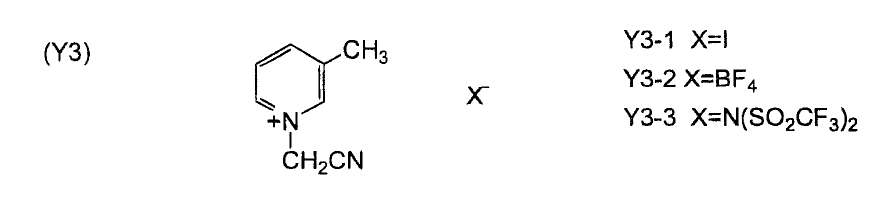

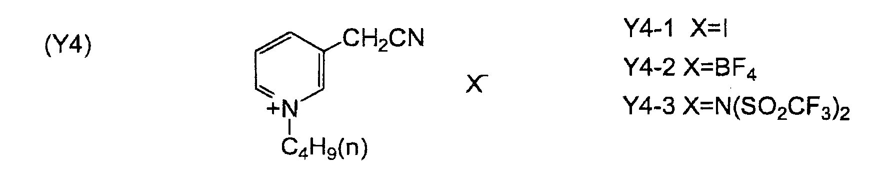

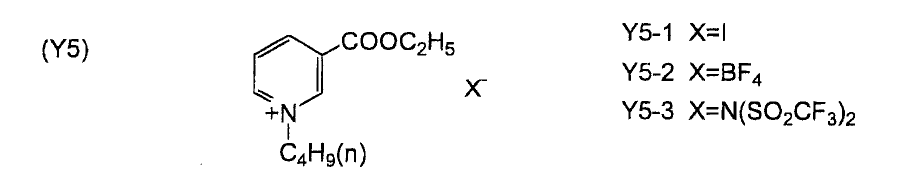

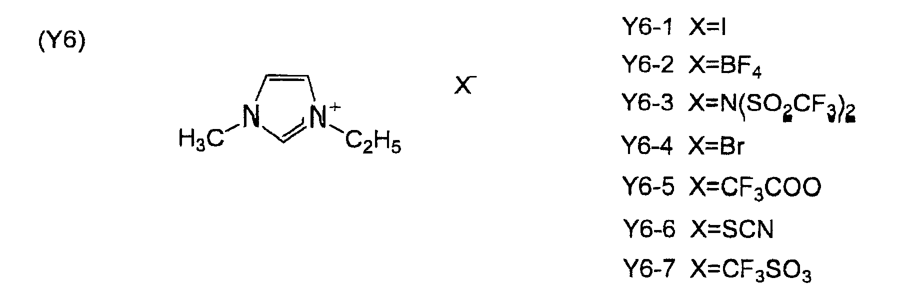

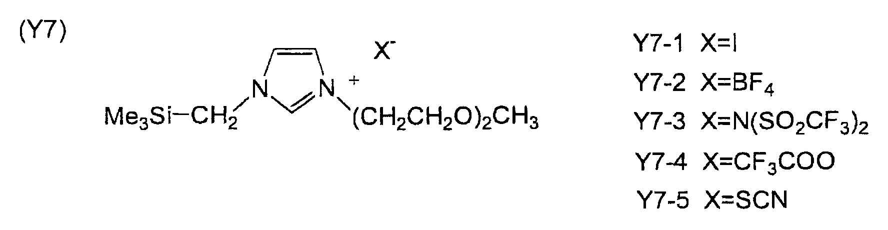

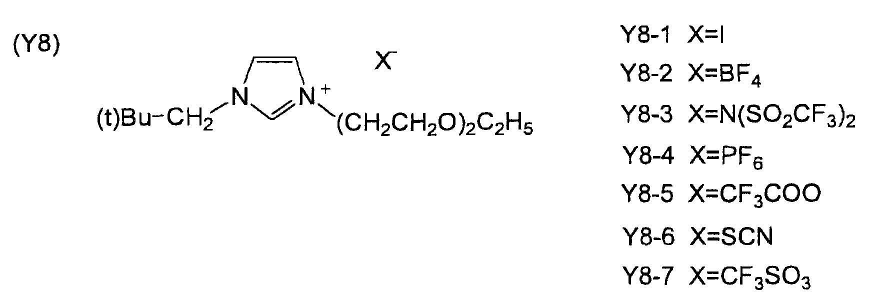

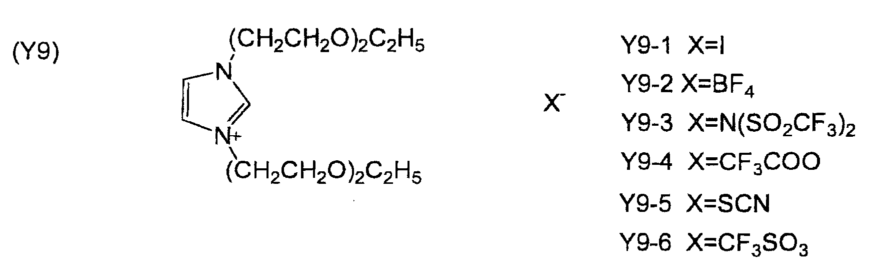

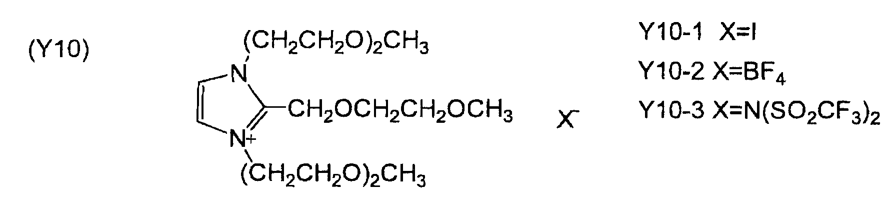

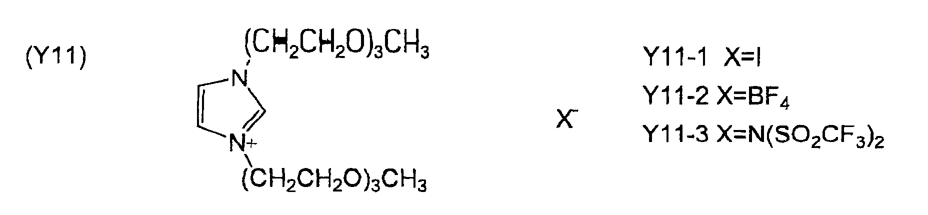

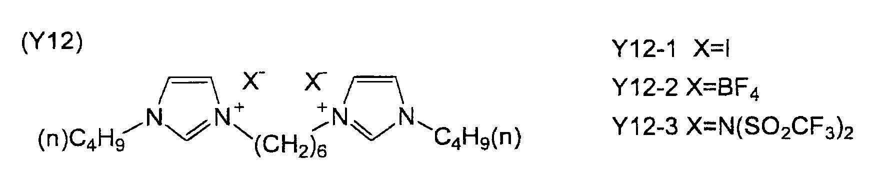

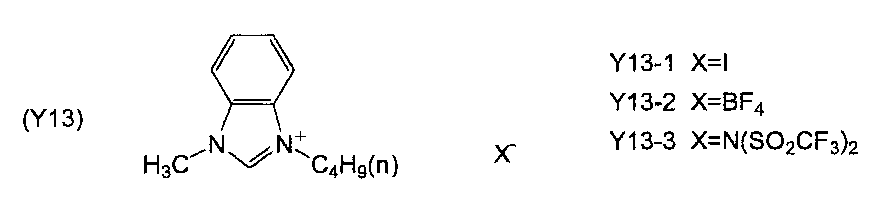

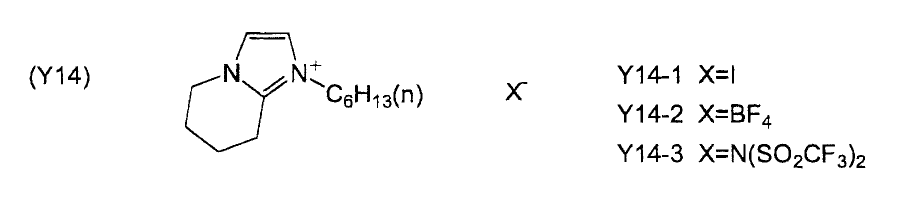

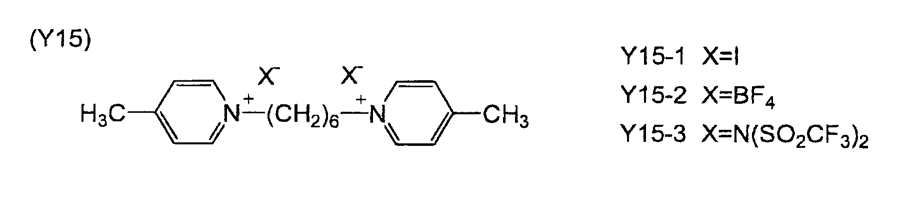

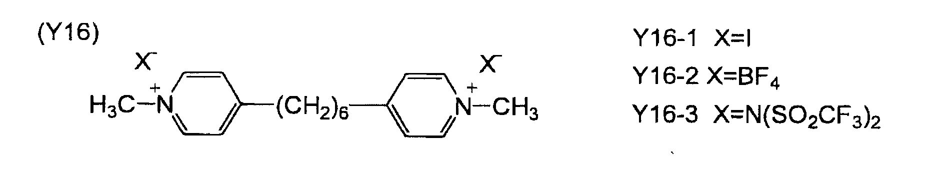

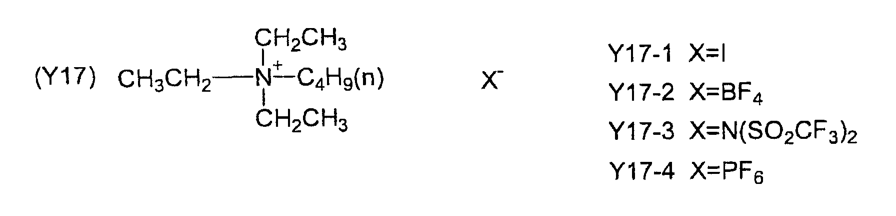

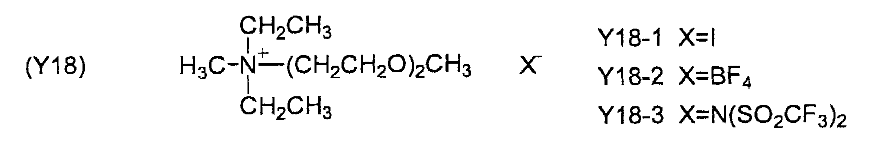

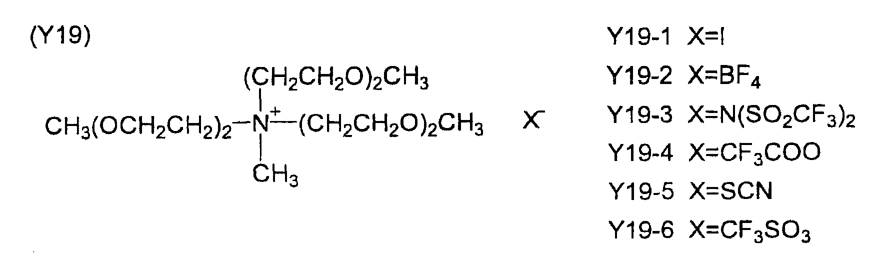

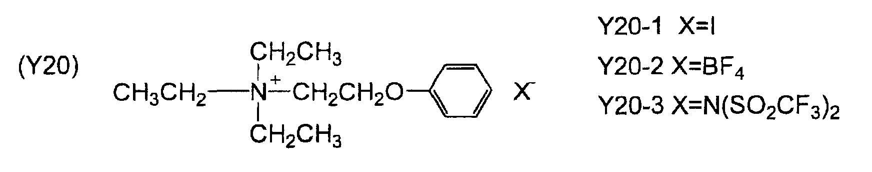

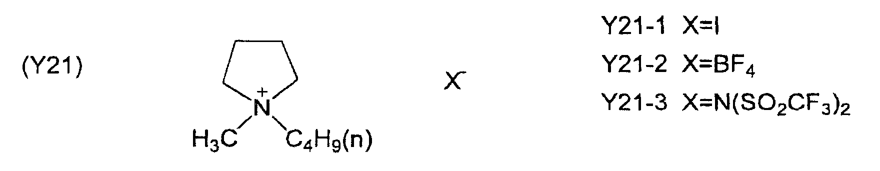

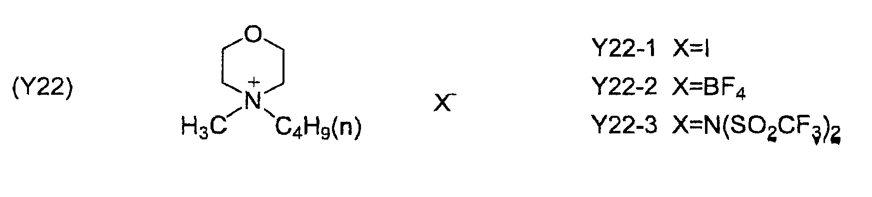

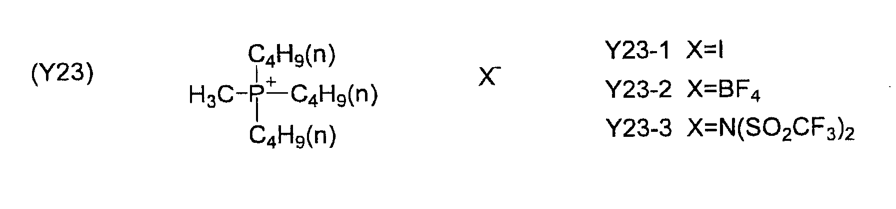

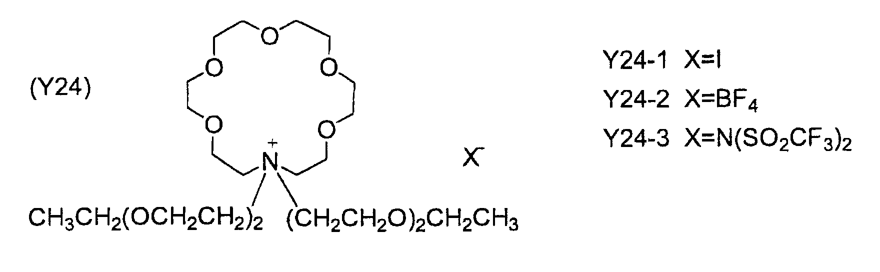

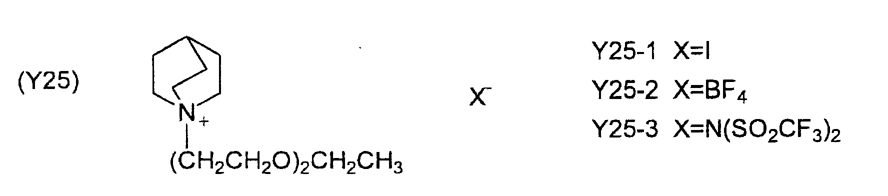

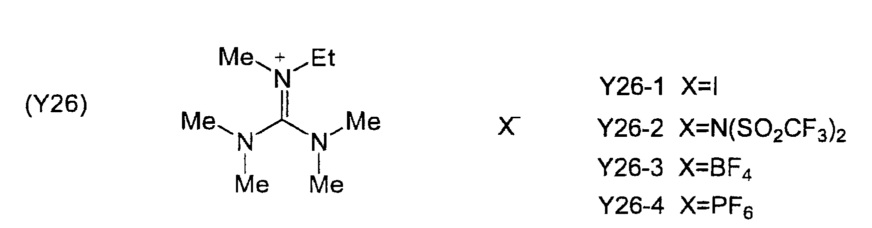

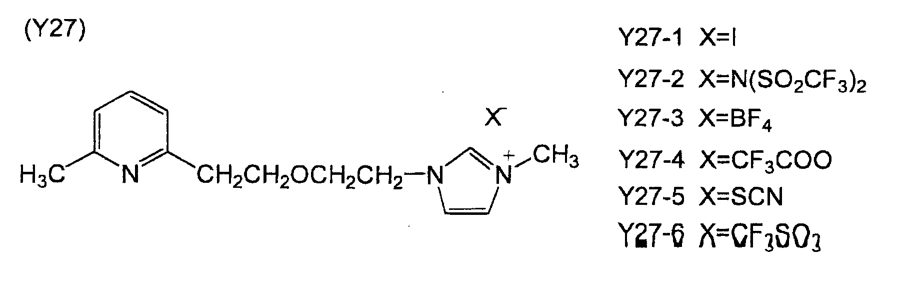

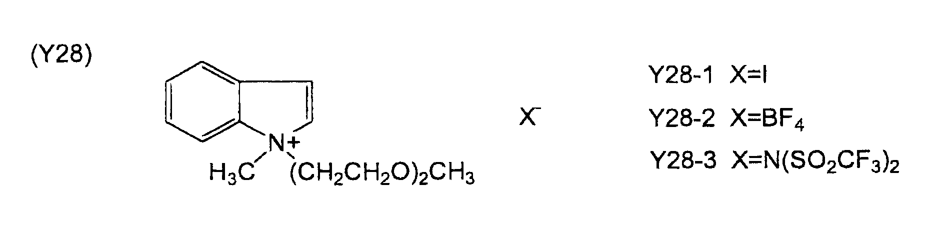

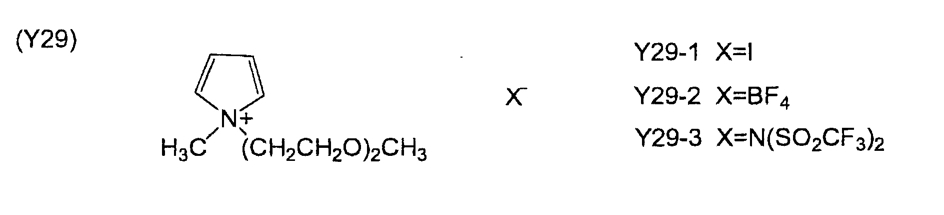

Though the molten salt electrolyte composition may comprise a solvent described below, it particularly preferably comprises no solvent. The content of the molten salt electrolyte is preferably 50 weight % or more, particularly preferably 90 weight % or more, based on the entire composition. The weight ratio of the iodine salts contained in the molten salt electrolyte composition is preferably 50 weight % or more to the entire salts contained therein.

The molten salt electrolyte composition preferably comprises iodine. The iodine-content is preferably 0.1 to 20 weight %, more preferably 0.5 to 5 weight % based on the entire composition.

### (2) Electrolysis Solution

The electrolysis solution used in the present invention is preferably composed of an electrolyte, a solvent and an additive. The electrolyte may be: a combination of I₂ and an iodide (a metal iodide such as LiI, NaI, KI, CsI and CaI₂, a quaternary ammonium iodide such as a tetralkylammonium iodide, pyridinium iodide and imidazolium iodide, etc.); a combination of Br₂ and a bromide (a metal bromide such as LiBr, NaBr, KBr, CsBr and CaBr₂, a quaternary ammonium bromide such as a tetralkylammonium bromide and pyridinium bromide, etc.); a metal complex such as a ferrocyanide-ferricyanide and a ferrocene-ferricinium ion; a sulfur compound such as sodium polysulfide and an alkylthiol-alkyldisulfide; a viologen dye; hydroquinone-quinone; etc. Among them, preferred is a combination of I₂ and LiI or the quaternary ammonium iodide. A plurality of the electrolytes may be mixed to be in use.

The concentration of the electrolyte in the electrolysis solution is preferably 0.1 to 10 M, more preferably 0.2 to 4 M. Further, the electrolysis solution may comprise iodine, and the concentration of iodine therein is preferably 0.01 to 0.5 M.

The solvent used for the electrolysis solution is preferably such that has a low viscosity and a high ionic mobility or has a high permittivity and can increase the actual carrier concentration of the electrolysis solution, to exhibit an excellent ionic conductibility. Examples of the solvent include: carbonates such as ethylene carbonate and propylene carbonate; heterocyclic compounds such as 3-methyl-2-oxazolidinone; ethers such as dioxan and diethyl ether; chain ethers such as ethyleneglycol dialkylethers, propyleneglycol dialkylethers, polyethyleneglycol dialkylethers and polypropyleneglycol dialkylethers; alcohols such as methanol, ethanol, ethyleneglycol monoalkylethers, propyleneglycol monoalkylethers, polyethyleneglycol monoalkylethers and polypropyleneglycol monoalkylethers; glycols such as ethylene glycol, propylene glycol, polyethylene glycol, polypropylene glycol and glycerin; nitrile compounds such as acetonitrile, glutarodinitrile, methoxyacetonitrile, propionitrile and benzonitrile; aprotic polar solvents such as dimethylsulfoxide (DMSO) and sulfolane; water; etc. These solvents may be used in combination with each other.

To the above-mentioned molten salt electrolyte composition and the electrolysis solution is preferably added a basic compound such as *t*-butylpyridine, 2-picoline, 2,6-lutidine, etc., as described in J. Am. Ceram. Soc., 80 (12), 3157 to 3171 (1997), The concentration of the basic compound therein is preferably 0.05 to 2 M.

### (3) Gel Electrolyte Composition

The molten salt electrolyte composition and the electrolysis solution mentioned above may be gelled or solidified to prepare the gel electrolyte composition. Gelation may be achieved by: adding a polymer; adding an oil-gelling agent; polymerization of monomers including a multifunctional monomer; a cross-linking reaction of a polymer; etc.

In the case where the gel electrolyte composition is prepared by adding a polymer, compounds described in "Polymer Electrolyte Reviews 1 and 2", edited by J. R. MacCallum and C. A. Vincent, ELSEIVER APPLIED SCIENCE may be used as the polymer. Of the compounds, polyacrylonitrile and poly(vinylidene fluoride) are preferred.

In the case where the gel electrolyte composition is prepared by adding an oil-gelling agent, compounds described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used as the oil-gelling agent. Of the compounds, preferred are those having an amide structure.

In the case where the gel electrolyte composition is prepared by a cross-linking reaction of a polymer, it is preferable that a polymer containing a group having cross-linking reactivity is used in combination with a cross-linking agent. The group having the cross-linking reactivity is preferably an amino group or a nitrogen-containing heterocyclic group such as a pyridyl group, an imidazolyl group, a thiazolyl group, an oxazolyl group, a triazolyl group, a morpholyl group, a piperidyl group, a piperazyl group, etc. The cross-linking agent is preferably an electrophilic agent having a plurality of functional groups that may be attacked by the nitrogen atom, for example, multi-functional alkyl halides, aralkyl halides, sulfonates, acid anhydrides, acyl chlorides, isocyanates, α,β-unsaturated sulfonyl compounds, α,β-unsaturated carbonyl compounds, α,β-unsaturated nitrile compounds, etc. Cross-linking methods disclosed in Japanese Patent Laid-Open Nos. 2000-17076 and 2000-86724 may be used in the present invention.

Further, a method for gelling an electrolysis solution disclosed in Japanese Patent Laid-Open No. 11-185863 and a method for gelling a molten salt electrolyte composition disclosed in Japanese Patent Laid-Open No. 2000-58140 may be used in this invention.

### (4) Hole-Transporting Material

In the present invention, an organic solid hole-transporting material, an inorganic solid hole-transporting material or a combination thereof may be used for the charge transfer layer instead of the ion conductive electrolyte composition such as the molten salt electrolyte composition.

### (a) Organic Hole-Transporting Material

Preferred examples of the organic hole-transporting material used in this invention include: aromatic amines disclosed in J. Hagen, et al., Synthetic Metal, 89, 215 to 220 (1997), Nature, Vol. 395, 8 Oct. 1998, Page 583 to 585, WO 97/10617, United States Patent Nos. 4,923,774 and 4,764,625, Japanese Patent Laid-Open Nos. 59-194393, 5-234681, 4-308688, 3-269084, 4-129271, 4-175395, 4-264189, 4-290851, 4-364153, 5-25473, 5-239455, 5-320634, 6-1972, 7-138562, 7-252474 and 11-144773, etc.; triphenylenes disclosed in Japanese Patent Laid-Open Nos. 11-149821, 11-148067 and 11-176489, etc.; oligothiophene compounds disclosed in Adv. Mater., 9, No. 7, 557, 1997, Angew. Chem. Int. Ed. Engl., 34, 3, 303 to 307, 1995, J. Am. Chem. Soc., Vol. 120, No. 4, Page 664 to 672, 1998, etc.; and conductive polymers such as polypyrrole disclosed in K. Murakoshi, et al., Chem. Lett., 471, 1997 and polyacetylene, poly(*p*-phenylene), poly(*p*-phenylenevinylene), polythienylenevinylene, polythiophene, polyaniline, polytoluidine and derivatives thereof disclosed in "Handbook of Organic Conductive Molecules and Polymers", Vols. 1 to 4, edited by NALWA, published by WILEY.

As described in Nature, Vol. 395, 8 Oct. 583 to 585 (1998), to the organic hole-transporting material may be added a compound having cation radical such as tris(4-bromophenyl)aminium hexachloroantimonate to control the dopant level, or a salt such as Li[(CF₃SO₂)₂N] to achieve potential-control of surface of the semiconductor, thereby compensating a space-charge layer.

### (b) Inorganic Hole-Transporting Material

The inorganic hole-transporting material may be composed of a p-type inorganic compound semiconductor. Band gap of the p-type inorganic compound semiconductor is preferably 2 eV or more, more preferably 2.5 eV or more. Ionization potential of the p-type inorganic compound semiconductor should be smaller than that of the photosensitive layer to reduce holes of the dye. Although the ionization potential of the p-type inorganic compound semiconductor may be selected depending on the kind of the dye, generally, it is preferably 4.5 to 5.5 eV, more preferably 4.7 to 5.3 eV. The p-type inorganic compound semiconductor is preferably a compound having a monovalent copper such as CuI, CuSCN, CuInSe₂, Cu(In,Ga)Se₂, CuGaSe₂, Cu₂O, CuS, CuGaS₂, CuInS₂, CuAlSe₂, etc. Among them, CuI and CuSCN are preferred, and CuI is the most preferred. GaP, NiO, CoO, FeO, Bi₂O₃, MoO₂, Cr₂O₃, etc. are also used as the p-type inorganic compound semiconductor.

### (5) Method for Forming Charge Transfer Layer

The charge transfer layer may be provided by any of the following two methods. One is a method where the counter electrode is stuck on the photosensitive layer beforehand and the material for the charge transfer layer in the liquid state is made to penetrate a gap therebetween. Another is a method where the charge transfer layer is directly provided on the photosensitive layer, the counter electrode being then formed thereon.

In the former method, the material for the charge transfer layer may be made to penetrate the gap by a normal pressure process utilizing capillarity, or by a reduced pressure process where the material is pumped up from the gap to replace gas phase therein with liquid phase.

In the case of providing a wet charge transfer layer by the latter method, the wet charge transfer layer is applied to the photosensitive layer, the counter electrode is disposed on the wet charge transfer layer without drying it, and edges thereof is subjected to a treatment for preventing liquid-leakage, if necessary. In the case of providing a gel charge transfer layer by the latter method, the charge transfer material may be applied in the liquid state and gelled by polymerization, etc. In this case, the counter electrode may be disposed on the charge transfer layer before or after drying and fixing the charge transfer layer.

The charge transfer layer composed of the electrolysis solution, the wet organic hole-transporting material, the gel electrolyte composition, etc. may be disposed by a roller method, a dip method, an air-knife method, an extrusion method, a slide-hopper method, a wire-bar method, a spin method, a spray method, a cast method, various printing methods, etc. similarly to the case of forming the semiconductor fine particle layer, or adsorbing a dye to the semiconductor mentioned above.

The charge transfer layer composed of the solid electrolyte, the solid hole transporting material, etc. may be formed by a dry film-forming method such as a vacuum deposition method and a CVD method, and followed by disposing the counter electrode thereon. The organic hole-transporting material may be made to penetrate into the photosensitive layer by a vacuum deposition method, a cast method, a coating method, a spin-coating method, a soaking method, an electrolytic polymerization method, a photo-polymerization method, etc. The inorganic hole-transporting material may be made to penetrate into the photosensitive layer by a cast method, a coating method, a spin-coating method, a soaking method, an electrolytic deposition method, an electroless deposition method, etc.

### (D) Counter Electrode

The counter electrode is the counter electrically conductive layer, which is supported by the substrate, if necessary. Examples of the electrically conductive material used for the counter electrically conductive layer include: metals such as platinum, gold, silver, copper, aluminum, magnesium and indium; carbon; and electrically conductive metal oxides such as indium-tin composite oxides and fluorine-doped tin oxides. Among them, preferred are platinum, gold, silver, copper, aluminum and magnesium. The substrate of the counter electrode is preferably made of a glass or a plastic to be coated or vapor-deposited with the electrically conductive material. The counter electrically conductive layer preferably has a thickness of 3 nm to 10 µm, although the thickness is not particularly limited. The surface resistance of the counter electrically conductive layer is desirably as low as possible. The surface resistance is preferably 50 Ω/square or less, more preferably 20 Ω/square or less.

Light may be irradiated from any one or both side of the conductive support and the counter electrode, so that at least one of them should be substantially transparent to have light reached to the photosensitive layer. From a viewpoint of improving electric generation efficiency, it is preferable that the conductive support is substantially transparent to irradiate light therethrough. In this case, the counter electrode preferably has a light-reflective property. Such a counter electrode may be composed of a glass or a plastic having a vapor-deposited layer of a metal or an electrically conductive oxide, or a metal thin film.

The counter electrode may be disposed by applying, metal-plating or vapor-depositing (PVD, CVD, etc.) the electrically conductive material directly onto the charge transfer layer. It is preferable that the metal lead is used to reduce the resistance of the counter electrode, as similar to the conductive support. The metal lead is particularly preferably used for the transparent counter electrode. Preferable embodiments of the metal lead used for the counter electrode are the same as those of the metal lead used for the conductive support mentioned above.

### (E) Others

It is preferable that a fine semiconductor thin film is provided between the conductive support and the photosensitive layer as an undercoating layer to prevent short-circuit of the counter electrode and the conductive support, particularly in the case of the charge transfer layer composed of the electron-transporting material or the hole-transporting material. The undercoating layer is preferably made of TiO₂, SnO₂, Fe₂O₃, WO₃, ZnO or Nb₂O₅, more preferably made of TiO₂. The undercoating layer may be disposed by a spray-pyrolysis method described in Electrochim. Acta, 40, 643 to 652 (1995), a sputtering method, etc. The thickness of the undercoating layer is preferably 5 to 1000 nm, more preferably 10 to 500 nm.

Functional layers such as a protective layer and a reflection-preventing layer may be disposed on any one or both of the conductive support and the counter electrode. The functional layers may be disposed by a method selected in accordance with the materials therefor, such as a coating method, a vapor-deposition method and a sticking method.

### (F) Interior Structure of Photoelectric Conversion Device

As described above, the photoelectric conversion device may have various interior structures in accordance with an end of use. The structures are classified into two major forms, a structure allowing light incidence from both faces, and a structure allowing it from only one face. Each of Figs. 2 to 9 illustrates an example of the interior structure of the photoelectric conversion device, which is preferable in the present invention.

In the structure illustrated in Fig. 2, the photosensitive layer 20 and the charge transfer layer 30 are disposed between the transparent electrically conductive layer 10a and the transparent counter electrically conductive layer 40a. This structure allows light incidence from both faces of the device.

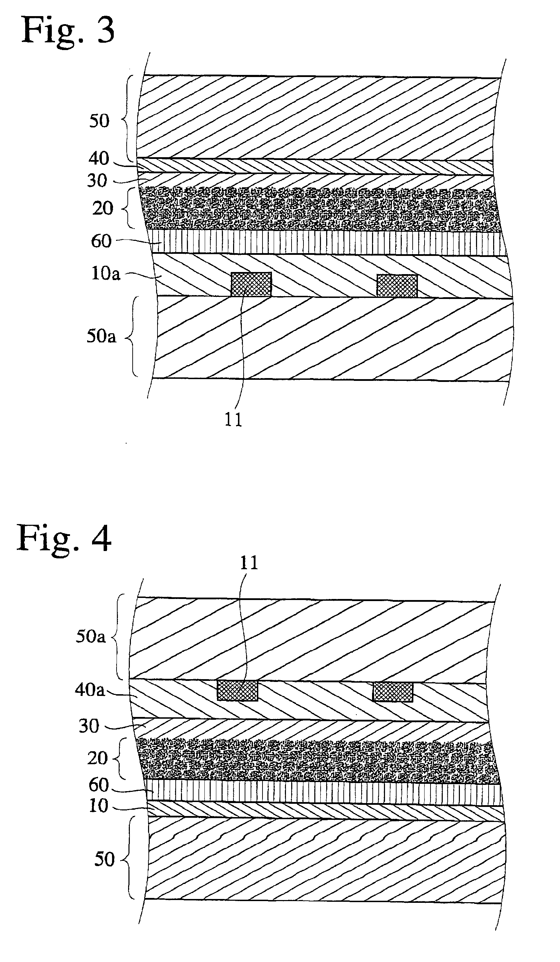

In the structure illustrated in Fig. 3, on the transparent substrate 50a partially having the metal lead 11 is disposed the transparent electrically conductive layer 10a, the undercoating layer 60, the photosensitive layer 20, the charge transfer layer 30 and the counter electrically conductive layer 40 are laminated in this order, and the substrate 50 is further placed thereon. This structure allows light incidence from the electrically conductive layer side.

In the structure illustrated in Fig. 4, the photosensitive layer 20 is disposed on the substrate 50 having the electrically conductive layer 10 through the undercoating layer 60, the charge transfer layer 30 and the transparent counter electrically conductive layer 40a are disposed thereon, and further the transparent substrate 50a locally having the metal lead 11 is placed on the counter electrically conductive layer 40a so that the metal lead 11 side orients inward. This structure allows light incidence from the counter electrode side.

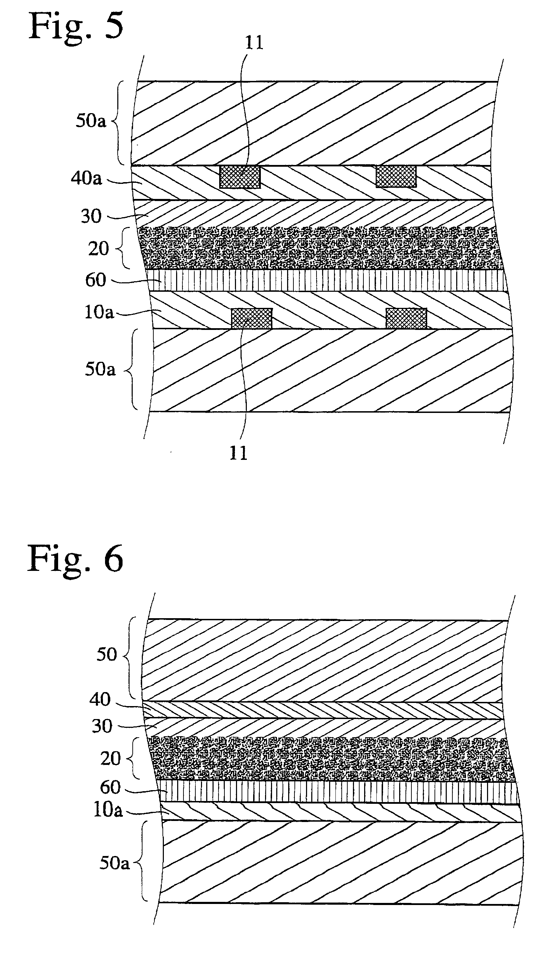

In the structure illustrated in Fig. 5, on the two transparent substrates 50a each having the metal lead 11 partially are formed the transparent electrically conductive layer 10a and the transparent counter electrically conductive layer 40a, respectively, and the undercoating layer 60, the photosensitive layer 20 and the charge transfer layer 30 placed between the conductive layers. This structure allows light incidence from both faces of the photoelectric conversion device.

In the structure illustrated in Fig. 6, on the transparent substrate 50a having the transparent electrically conductive layer 10a is disposed the photosensitive layer 20 through the undercoating layer 60, the charge transfer layer 30 and the counter electrically conductive layer 40 are formed thereon, and further the substrate 50 is placed on the counter electrically conductive layer 40. This structure allows light incidence from the electrically conductive layer side.

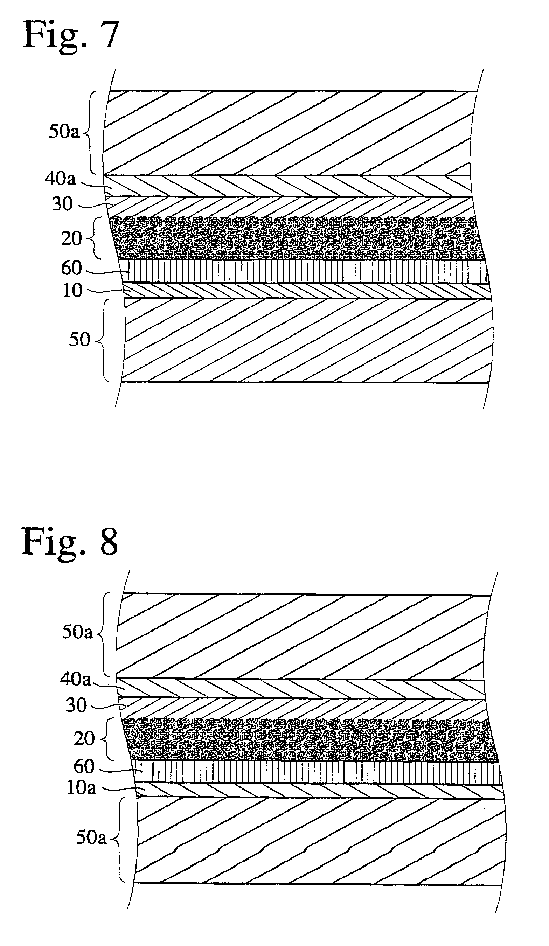

In the structure illustrated in Fig. 7, on the substrate 50 having the electrically conductive layer 10 is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from the counter electrode side.

In the structure illustrated in Fig. 8, on the transparent substrate 50a having the transparent electrically conductive layer 10a is disposed the photosensitive layer 20 through the undercoating layer 60, the charge transfer layer 30 and the transparent counter electrically conductive layer 40a are formed thereon, and further the transparent substrate 50a is placed on the layer 40a. This structure allows light incidence from both faces of the photoelectric conversion device.

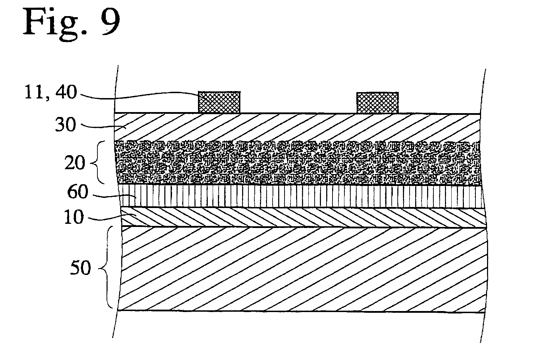

In the structure illustrated in Fig. 9, the photosensitive layer 20 is disposed on the substrate 50 having the electrically conductive layer 10 through the undercoating layer 60, the solid charge transfer layer 30 is disposed thereon, and further the counter electrically conductive layer 40 or the metal lead 11 is locally placed on the solid charge transfer layer 30. This structure allows light incidence from the counter electrode side.

### [3] Photoelectric Cell

The photoelectric cell of the present invention is constituted by connecting the photoelectric conversion device of the present invention to an external circuit to electrically work or generate electricity in the external circuit. Such a photoelectric cell that has the charge transfer layer composed of the ion conductive electrolyte composition is generally referred to as a photo-electrochemical cell. A photoelectric cell intended for power generation utilizing solar light is generally referred to as a solar cell.

The side face of the photoelectric cell is preferably sealed with a polymer or an adhesive agent, etc. to prevent deterioration and volatility of the content in the cell. The external circuit is connected to the conductive support and the counter electrode via a lead. Various known circuits may be used in the present invention.

In the case where the photoelectric conversion device of the present invention is used as the solar cell, the interior structure of the solar cell may be essentially the same as that of the photoelectric conversion device mentioned above. The solar cell comprising the photoelectric conversion device of the present invention may have a known module structure. In general module structure of the solar cell, cells are placed on a substrate of metal, ceramic, etc. and covered with a packing resin, a protective glass, etc., whereby light is introduced from the opposite side of the substrate. The solar cell module may have a structure where the cells are placed on a substrate of a transparent material such as a tempered glass to introduce light from the transparent substrate side. Specifically, a superstraight type module structure, a substrate type module structure, a potting type module structure, substrate-integrated type module structure that is generally used in amorphous silicon solar cells, etc. are known as the solar cell module structure. The solar cell comprising the photoelectric conversion device of the present invention may have a module structure properly selected from the above structures in accordance with ends and environment at use, and preferably has a module structure disclosed in Japanese Patent Laid-Open No. 2000-268892.

### EXAMPLES

The present invention will be explained in more detail with reference to examples below without intention of restricting the scope of the present invention.

### Example 1. Synthesis of Metal Complex Dye

Syntheses of the metal complex dyes S-1, S-4 and S-5 for use in the photoelectric conversion device of the present invention will be described below, the present invention being not restricted thereby. Because groups -CO-, -SO-, -SO₂- and -PO₂- in the structure -V₁-NH-V₂- exhibit a similar properties in the syntheses, the groups can be easily replaced with each other therein.

### (1) Synthesis of Metal Complex Dye S-1

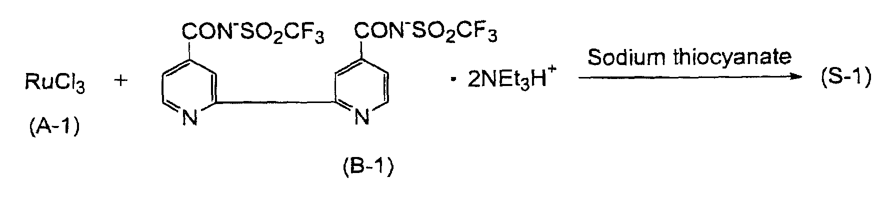

0.17 g of the compound A-1 and 0.48 g of the compound B-1 were dissolved in 20 ml of dimethylformamide and heated at 120 °C under nitrogen for 4 hours. Then, 0.26 g of sodium thiocyanate was added to the resulting mixture, and further heated at 120 °C for 4 hours. This reaction mixture was cooled and concentrated, and the residue was purified by "Sephadex Column LH-20" (developing solvent: methanol) followed by neutralization, to obtain 0.20 g of the metal complex dye S-1 as crystal. Structure of the product was identified by NMR and MS spectra. Thus-obtained metal complex dye S-1 exhibited an absorption maximum in visible wavelength region at 535 nm in MeOH.

### (2) Synthesis of Metal Complex Dye S-4

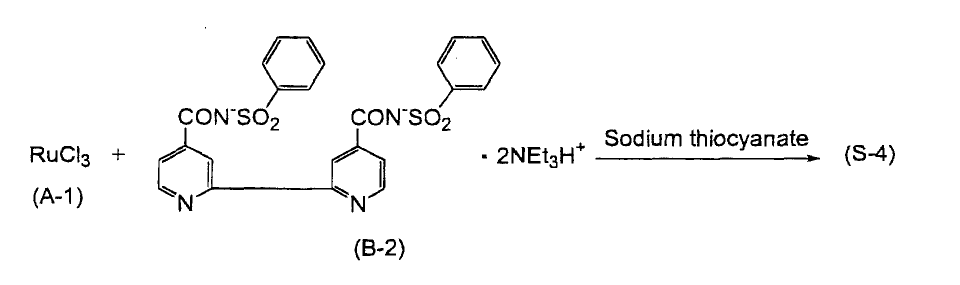

0.12 g of the compound A-1 and 0.36 g of the compound B-2 were dissolved in 15 ml of dimethylformamide and heated at 120 °C under nitrogen for 4 hours. Then, 0.19 g of sodium thiocyanate was added to the resulting mixture, and further heated at 120 °C for 4 hours. This reaction mixture was cooled and concentrated, and the residue was purified by "Sephadex Column LH-20" (developing solvent: methanol) followed by neutralization, to obtain 0.20 g of the metal complex dye S-4 as crystal. Structure of the product was identified by NMR and MS spectra. Thus-obtained metal complex dye S-4 exhibited an absorption maximum in visible wavelength region at 530 nm in MeOH.

### (3) Synthesis of Metal Complex Dye S-5

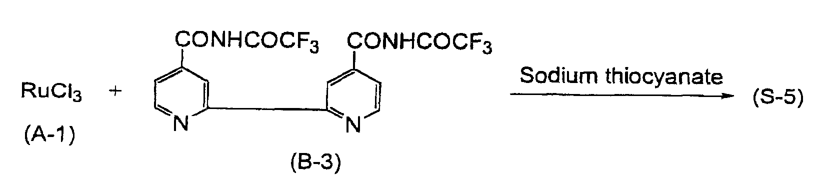

0.07 g of the compound A-1 and 0.13 g of the compound B-3 were dissolved in 10 ml of dimethylformamide and heated at 120 °C under nitrogen for 4 hours. Then, 0.12 g of sodium thiocyanate was added to the resulting mixture, and further heated at 120 °C for 4 hours. This reaction mixture was cooled and concentrated, and the residue was purified by "Sephadex Column LH-20" (developing solvent: methanol) followed by neutralization, to obtain 0.10 g of the metal complex dye S-5 as crystal. Structure of the product was identified by NMR and MS spectra. Thus-obtained metal complex dye S-5 exhibited an absorption maximum in visible wavelength region at 510 nm in MeOH.

Incidentally, each of the metal complex dyes S-1, S-4 and S-5 exhibited pKa value of 3 to 10.

### Example 2. Preparation of Titanium Dioxide Dispersion

15 g of titanium dioxide "Degussa P-25" manufactured by Nippon Aerosil K.K., 45 g of water, 1 g of dispersant "Triton X-100" manufactured by Aldrich and 30 g of zirconia beads having a diameter of 0.5 mm manufactured by Nikkato K.K. were charged in a stainless steel vessel coated with Teflon inside having an inner volume of 200 ml, and subjected to a dispersion treatment for 2 hours at 1500 rpm by means of a sand-grinder mill manufactured by Imex K.K. After the dispersion treatment, the zirconia beads were removed by filtration to obtain a titanium dioxide dispersion. The titanium dioxide particles in thus-obtained dispersion had an average particle diameter of 2.5 µm, the particle diameter being measured by Master Sizer manufactured by MALVERN.

### Example 3. Preparation of Dye-Sensitized TiO₂ Electrode

The above titanium dioxide dispersion was applied to an electrically conductive surface of a conductive glass having a fluorine-doped tin oxide coating by a glass bar. Used as the conductive glass was "TCO Glass-U" manufactured by Asahi Glass K.K. having a surface resistance of approximately 30 Ω/square, which was cut into 20 mm × 20 mm in size beforehand. Herein, an adhesive tape was attached to the electrically conductive surface of the conductive glass at portions of from the edge to 3 mm as a spacer, eight conductive glasses were arranged such that the adhesive tapes come to both edges thereof, and to the eight conductive glasses were applied the titanium dioxide dispersion at once. The titanium dioxide dispersion-applied conductive glass was air-dried for one day at a room temperature after peeling the adhesive tape. The amount of the applied titanium dioxide (semiconductor fine particle) was 20 g/m².

Then, the conductive glass was placed in an electric furnace "muffle furnace FP-32" manufactured by Yamato Science K.K., followed by burning at 450 °C for 30 minutes to obtain a TiO₂ electrode. After the TiO₂ electrode was taken out of the electric furnace and cooled, it was immersed in a methanol solution comprising the metal complex dye S-1 for 15 hours so that the dye is adsorbed on the titanium dioxide, further immersed in 4-*t*-butylpyridine for 15 minutes, washed with ethanol and air-dried to obtain a dye-sensitized TiO₂ electrode. The concentration of the dye S-1 in the methanol solution was 3 × 10⁻⁴ mol/l, and the thickness of thus-obtained photosensitive layer was 10 µm.

### Example 4. Production of Photoelectric Cell

The 20 mm × 20 mm in size of the dye-sensitized TiO₂ electrode prepared as described above was put on a platinum-deposited glass having the same size. Then, an electrolysis solution of 3-methoxypropionitrile comprising 0.65 mol/l of 1-methyl-3-hexylimidazolium iodide and 0.05 mol/l of iodine was permeated into a crevice between the glasses through capillarity and introduced into the dye-sensitized TiO₂ electrode, to obtain a photoelectric cell D-1.

Photoelectric cells D-2 to D-12 were produced in the same manner as the photoelectric cell D-1 except that the metal complex dyes shown in Table 1 were used instead of the metal complex dye S-1, respectively.

### Example 5. Measurement of Photoelectric Conversion Efficiency

A simulated sunlight was irradiated to each of the photoelectric cells D-1 to D-14, so that each photoelectric cell was measured with respect to the generated electricity by the current-voltage tester "Keithley SMU238" to obtain open circuit voltage (V). The results are shown in Table 1. Incidentally, the simulated sunlight was obtained by passing the light of a 500 W Xenone Lamp manufactured by Ushio K.K. through an "AM 1.5 filter" manufactured by Oriel Co. and a sharp cut filter "Kenko L-42". The simulated sunlight was free of ultraviolet rays and had intensity of 100 mW/cm².

**Table 1**

| Photoelectric Cell | Dye | Open Circuit Voltage (V) |
|---|---|---|
| D-1 | S-1 | 0.75 |
| D-2 | S-2 | 0.70 |
| D-3 | S-3 | 0.72 |
| D-4 | S-4 | 0.73 |
| D-5 | S-5 | 0.68 |
| D-6 | S-6 | 0.77 |
| D-7 | S-7 | 0.70 |
| D-8 | S-8 | 0.71 |
| D-9 | S-9 | 0.71 |
| D-10 | S-10 | 0.65 |
| D-11 | S-11 | 0.68 |
| D-12 | S-12 | 0.65 |
| D-13 | S-13 | 0.66 |
| D-14 | Comparative Dye 1 | 0.55 |

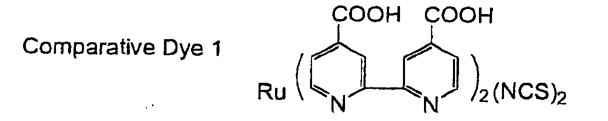

As shown in Table 1, each photoelectric cell D-1 to D-13 composed of the photoelectric conversion device of the present invention were excellent in the open circuit voltage as compared with the photoelectric cell D-14 using the known, Comparative Dye 1.

As described in detail above, a photoelectric conversion device and a photoelectric cell of the present invention comprises a dye having a proton dissociative imide group to have a high open circuit voltage.

## Claims

1. A photoelectric conversion device comprising a semiconductor fine particle sensitized by a dye, wherein said dye has a proton dissociative imide group.

2. The photoelectric conversion device according to claim 1, wherein said proton dissociative imide group has a pKa value of 14 or less.

3. The photoelectric conversion device according to claim 1 or 2, wherein said dye has a -V₁-NH-V₂- group in which V₁ and V₂ independently represent -CO-, -SO-, -SO₂- or -PO₂-.

4. The photoelectric conversion device according to any one of claims 1 to 3, wherein said dye is a metal complex dye.

5. The photoelectric conversion device according to claim 4, wherein said metal complex dye is represented by the following general formula (I):
M(La)ₘ₁(Lb)ₘ₂(X)ₘ₃·Cl (I)
wherein M is a metal atom;
La is a bidentate or tridentate ligand represented by the following general formula (II): 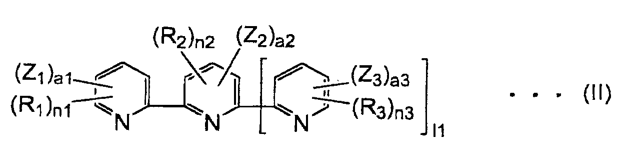 wherein Z₁, Z₂ and Z₃ independently represent a dissociative group of -V₁-NH-V₂-R in which V₁ and V₂ independently represent -CO-, -SO-, -SO₂- or -PO₂-and R represents a hydrogen atom, an aliphatic hydrocarbon group, an aromatic hydrocarbon group, a heterocyclic group, an amino group or an alkoxy group, R₁, R₂ and R₃ independently represent a substituent, a1, a2 and a3 independently represent an integer of 0 to 2, the total of a1 and a2 is 1 to 4, R's may be the same or different and may bond together when the total of a1, a2 and a3 is 2 or more, n1, n2 and n3 independently represent an integer of 0 to 4, R₁'s may be the same or different substituents that may bond together when n I is 2 or more, R₂'s may be the same or different substituents that may bond together when n2 is 2 or more, R₃'s may be the same or different substituents that may bond together when n3 is 2 or more, 11 represents an integer of 0 or 1, and Z₂ and R₂ may bond to the carbon atom adjacent to the nitrogen atom of the pyridine ring when 11 is 0;
Lb is a bidentate or tridentate ligand represented by the following general formula (III): 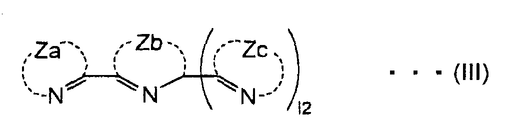 wherein Za, Zb and Zc independently represent nonmetallic atoms forming a 5-or 6-membered ring and 12 represents an integer of 0 or 1;
X is a monodentate or bidentate ligand;
m1 is an integer of 1 to 3, m2 is an integer of 0 to 2 and m3 is an integer of 0 to 4; and
CI is a counter ion optionally contained to neutralize charge of said metal complex dye.

6. The photoelectric conversion device according to claim 5, wherein said Z₁, Z₂ and Z₃ independently represent a -CONHSO₂R group, a -CONHCOR group, a -SO₂NHSO₂R group or a -SO₂NHCOR group.

7. The photoelectric conversion device according to claim 5 or 6, wherein said ml is 2 or 3 and said m2 is 0.

8. The photoelectric conversion device according to any one of claims 1 to 7, wherein said semiconductor fine particle is a titanium oxide fine particle.

9. A photoelectric cell comprising the photoelectric conversion device recited in any one of claims 1 to 8.

10. A metal complex dye represented by the following general formula (I):
M(La)ₘ₁(Lb)ₘ₂(X)ₘ₃·Cl (I)
wherein M is a metal atom;
La is a bidentate or tridentate ligand represented by the following general formula (II): 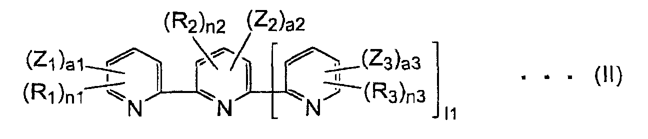 wherein Z₁, Z₂ and Z₃ independently represent a dissociative group of -V₁-NH-V₂-R in which V₁ and V₂ independently represent -CO-, -SO-, -SO₂- or -PO₂- and R represents a hydrogen atom, an aliphatic hydrocarbon group, an aromatic hydrocarbon group, a heterocyclic group, an amino group or an alkoxy group, R₁, R₂ and R₃ independently represent a substituent, a1, a2 and a3 independently represent an integer of 0 to 2, the total of a1 and a2 is 1 to 4, R's may be the same or different and may bond together when the total of a1, a2 and a3 is 2 or more, n1, n2 and n3 independently represent an integer of 0 to 4, R₁'s may be the same or different substituents that may bond together when n1 is 2 or more, R₂'s may be the same or different substituents that may bond together when n2 is 2 or more, R₃'s may be the same or different substituents that may bond together when n3 is 2 or more, 11 represents an integer of 0 or 1, and Z₂ and R₂ may bond to the carbon atom adjacent to the nitrogen atom of the pyridine ring when 11 is 0;
Lb is a bidentate or tridentate ligand represented by the following general formula (III): 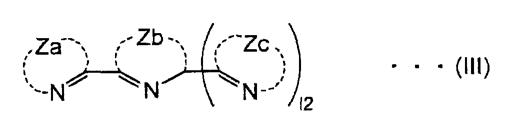 wherein Za, Zb and Zc independently represent nonmetallic atoms forming a 5-or 6-membered ring and 12 represents an integer of 0 or 1;
X is a monodentate or bidentate ligand;
m1 is an integer of 1 to 3, m2 is an integer of 0 to 2 and m3 is an integer of 0 to 4; and
CI is a counter ion optionally contained to neutralize charge of said metal complex dye.
